(19) Europäisches Patentamt
European Patent Office
Office européen des brevets

(11) EP 2 108 682 B1

(12) EUROPEAN PATENT SPECIFICATION

(45) Date of publication and mention of the grant of the patent:
**27.07.2016 Bulletin 2016/30**

(21) Application number: **07828909.7**

(22) Date of filing: **01.10.2007**

(51) Int Cl.:
***C09B 67/22*** (2006.01) ***G03F 7/00*** (2006.01)
***C09B 57/00*** (2006.01) ***C09B 67/48*** (2006.01)

(86) International application number:
**PCT/JP2007/069169**

(87) International publication number:
**WO 2008/044519 (17.04.2008 Gazette 2008/16)**

(54) **ALPHA-DIKETOPYRROLOPYRROLE PIGMENT, COLORING COMPOSITION CONTAINING THE SAME, AND RED FILM**

ALPHA-DIKETOPYRROLOPYRROLPIGMENT, ES ENTHALTENDE FARBGEBENDE ZUSAMMENSETZUNG SOWIE ROTER FILM

PIGMENT DE ALPHA-DICETOPYRROLOPYRROLE, COMPOSITION COLORANTE CONTENANT CELUI-CI, ET FILM ROUGE

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **06.10.2006 JP 2006275671**

(43) Date of publication of application:
**14.10.2009 Bulletin 2009/42**

(73) Proprietor: **Toyo Ink SC Holdings Co., Ltd.**
**Tokyo 104-8377 (JP)**

(72) Inventors:
- **SATO, Takeshi**
  **Tokyo 1048377 (JP)**
- **OMURA, Toru**
  **Tokyo 1048377 (JP)**
- **MUROHOSHI, Taro**
  **Tokyo 1048377 (JP)**
- **TAKABATAKE, Yoshiko**
  **Tokyo 1048377 (JP)**
- **ARIYOSHI, Yasushi**
  **Tokyo 1048377 (JP)**

(74) Representative: **Neidl-Stippler, Cornelia**
**Neidl-Stippler**
**Patentanwaltskanzlei**
**Rauchstrasse 2**
**81679 München (DE)**

(56) References cited:
**EP-A1- 1 101 800** **WO-A1-2005/040284**
**JP-A- 2001 220 520** **JP-A- 2004 277 434**
**JP-A- 2005 002 249** **JP-A- 2005 002 249**
**JP-A- 2005 189 672** **JP-A- 2007 293 061**
**JP-A- 2007 293 061** **US-A- 5 808 094**

Remarks:
The file contains technical information submitted after the application was filed and not included in this specification

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

### Technical Field

The present invention relates to an α-diketopyrrolopyrrole pigment favorably used in a color filter for a color liquid crystal display or a solid state image sensor, a coloring composition containing the same and a red colored film formed by use of the coloring composition. More specifically, the present invention relates to a fine-particle α-diketopyrrolopyrrole pigment by use of which a red colored film having small absolute value of birefringence is given and that gives a color filter for a color liquid crystal display or a solid state image sensor with small viewing angle dependence and higher contrast ratio; a coloring composition containing the same; and a red colored film formed by use of the coloring composition.

### Background Art

Color liquid crystal displays normally have two polarization plates, a liquid crystal cell held between the polarization plates, and color filters having filter segments in red, green and blue. Each color filter segment in the color filter contains pigments as the colorant component. The light polarization plane polarized by the first polarization plate is rotated in the liquid crystal layer according to the image signal, and the transmitting amount of the rotated light individual pixel is adjusted by the second polarization plate, thus the image being displayed. Accordingly if the polarization plane of the light transmitting through the first polarization plate is disturbed by the color filter, the display characteristics of the display will decline. The contrast ratio of the color liquid crystal display, specifically, declines because of leakage of light on the black display mode or weakening of the transmitted light on the white mode.

The cause that the polarization plane of the transmitted light through the first polarization plate is disturbed by the color filter is considered that the polarized light by the first polarization plate is reflected on the pigment surface during transmission through the color filter to rotate the polarization plane, thus the polarized light being depolarized (depolarization). Therefore, to raise the contrast ratio of the color liquid crystal display, it is important to reduce the primary particle size of the pigment contained in the color filter to a size smaller than the wavelength of light and to minimize the difference in refractive index between the pigment and the medium. Minuteness of the primary particle of the pigment is generally conducted by mechanical pulverization of the pigment (see Patent Documents 1 and 2 below).

The methods of mechanically pulverizing the pigment and reducing the size of the primary particles include two methods, a dry pulverization method and a salt milling method.

The dry pulverization method is a method of disintegrating coarse primary particles of the pigment under the applied shock by an abrasive such as steel beads, zirconia beads or alumina beads in an apparatus such as a ball mill, an attriter or a vibrating mill. The method is effective in reducing the size of the primary particles, but also causes problems that there is frequently unpulverized residual pigment, and in addition, that there are easily generated very cohesive secondary particles of the crystals that are bonded to each other under the pressure by abrasive shock. Presence of coarse particles and very cohesive secondary particles is unfavorable in the color filter application.

On the other hand, the salt milling method is a method of pulverizing coarse primary particles of a pigment by blending the pigment coarse primary particles, an inorganic salt such as sodium chloride or sodium sulfate, and a water-soluble organic solvent such as diethylene glycol or propylene glycol under very strong load in a kneading machine such as a kneader. The blended material after kneading may be dissolved or dispersed in a great amount of water and the inorganic salt and the water-soluble organic solvent may be removed by subsequent filtration and water washing, to isolate a fine-primary particle pigment. In the salt milling method, the coarse pigment is wetted with the added water-soluble organic solvent to form an aggregate, so-called dough, and conduct pulverization of the pigment by kneading the aggregate, and thus, the pigment particles obtained are characteristically in the spherical shape, uniform in size, contains fewer unpulverized coarse particles. The salt milling method is a production method of pigment suitable for the color filter application.

However, when commercially available diketopyrrolopyrrole pigments with a primary particle diameter of approximately 50 to 70 nm such as Irgafor Red B-CF or Irgafor Red BT-CF, manufactured by Ciba Specialty Chemicals, are pulverized by the salt milling method, observed were phenomena that the main absorption wavelength in the spectroscopic absorption spectrum shifted toward longer wavelength and the intensity ratio of the peaks observed by X-ray diffraction varied because of slight change in the crystalline state of the crystal under strong force, although it was possible to obtain high contrast. In addition, when the finely pulverized pigment is used in a red filter segment for color filter, the resulting liquid crystal display had a problem that its view-angle dependence was unfavorable and the visibility from inclined direction was also unfavorable.

In contrast, known is a method of preparing a fine-primary particle diketopyrrolopyrrole pigment directly (see Patent Document 3 below). However, when the diketopyrrolopyrrole pigment (C.I. Pigment Red 254) is prepared by the method, the crystalline form of the diketopyrrolopyrrole pigment obtained was beta form or a mixture of alpha and beta

forms, not the alpha form desirable in the color filter application. The primary particle diameter of the diketopyrrolopyrrole pigment prepared by the method is 50 nm or more, and thus, the pigment is unfavorably more sensitive to light scattering and the red filter segment containing the pigment has lower contrast ratio.

JP 2005002249 A **discloses that the fine and transparent dichlorodiketopyrrolopyrrole pigment (CI Pigment RED 254) with ≥ 80% permeability at 650 nm wavelength, whereas the position of the lowest transmission factor of the transpissionspectrom of the pigment is 560nm to 570 nm and the pigment has a blue hue, is obtained by that a ratio (24.5°/25.7°) of the diffracted intensities at Bragg angle (20) of X-Ray powder diffraction measured by CuKα-radiation is kept to ≤1 and the particle diameter of the pigment is made smaller**. **The dichlorodiketopyrrolopyrrole pigment is used for forming a red pigmented layer.**

EP11018900 A1 **discloses an α-II-Form of a 1,4diketo-3,6-di(4't-butylphenyl)-2,5-dihydro pyrrole [3,4-c]pyrrole pigment having different color characteristic and X-diffraction pattern. The pigment has a narrow particle size distribution with at last 50% of the particles having a primary pigment particle size in the range of from 0.1 to 0,5 μm and an X-ray diffraction pattern that exhibits two strong peaks corresponding ± 0.2 two 8 double glancing angles of 5.6 and 23.2, two medium strength peaks corresponding to 16.1 and 27.2 and eight weak peaks corresponding to 12.3 12.9 15.4 17.0 17.4 17.9 20.0 and 24.6.**

Patent Document 1: JP-A-2001-220520
Patent Document 2: JP-A-2005-189672
Patent Document 3: JP-A-07-90189

Disclosure of the invention

Problems to be solved by the Invention

An object of the present invention is to provide an α-diketopynolopyrrole pigment that does not have the problems above and a red coloring composition and a red colored film containing the same.

Specifically, the object of the present invention is to provide an a-diketopyrrolopyrrole pigment that has higher contrast ratio and a smaller absolute birefringence and thus, gives a color liquid crystal display with smaller view-angle dependence and superior display characteristics when used in a colored film, for example a red filter segment of the color filter for color liquid crystal display or solid state image sensor, a red coloring composition containing the same, and a red colored film formed by use of the coloring composition.

Means for Solving the Problems

After intensive studies, the inventors have found that a red colored film containing an α-diketopyrrolopyrrole pigment, wherein in the X-ray diffraction spectrum of the pigment, the ratio of the peak intensity ($I_{020}$) for plane index (020) that corresponds to peak intensity of 7.5 degrees in double glancing angles (2 theta) of the X-ray diffraction pattern, to the peak intensity ($I\text{-}_{141}$) for plane index (-141) , that corresponds to peak intensity of 25.8 degrees in double glancing angles (2 theta) plane the X-ray (-141) diffraction pattern, $I_{020}/I\text{-}_{141}$ is 0.40 or lower, and the ratio of the peak intensity ($I_{-141}$) for plane index (-141) to the peak intensity ($I_{111}$) for plane index (111), that corresponds to peak intensity of 24.7 degrees in double glancing angles (2theta) of the X-ray diffraction pattern, $I\text{-}_{141}/I_{111}$ is 1.28 or lower in the X-ray diffraction spectrum, and which has small absolute birefringence and gives a red filter segment for color filter having superior display characteristics such as small view-angle dependence and high contrast ratio, and the present invention being made, based on this finding. The inventors also found a method of producing the pigment with the properties described above.

Accordingly, the present invention relates to diketopyrrolopyrrole pigments, coloring compositions and red colored films in the following aspects (1) to (6):

(1) An α-diketopyrrolopyrrote pigment, wherein in the X-ray diffraction spectrum of the pigment, the ratio of the peak intensity ($I_{020}$) for Plane index (020) that corresponds to peak intensity of 7.5 degrees in double glancing angles (2 theta) of the X-ray diffraction pattern, to the peak intensity ($I\text{-}_{141}$) fior plane index (-141), that corresponds to peak intensity of 25.8 degrees in double glancing angles (2 theta) of the X-ray diffraction pattern, $I_{020}/I\text{-}_{141}$ is 0.40 or lower, and the ratio of the peak intensity ($L_{141}$) for plane index (-141) to the peak intensity ($I_{111}$) for plane index (111), that corresponds to peak intensity of 24.7 degrees in double glancing angles (2theta) of the X-ray diffraction pattern, $I\text{-}_{141}/I_{111}$ is 128 or lower

(2) The α-diketopyrrolopyrrole pigment described in aspect (1), wherein the average primary particle diameter of the α-diketopyrrolopyrrole is 40 nm or less.

(3) A coloring composition containing the α-diketopyrrolopyrrole pigment described in aspect (1) or (2) and a pigment

carrier.

(4) A red colored film containing the α-diketopyrrolopyrrole pigment described in aspect (1) or (2) and a pigment carrier.

(5) The red colored film described in aspect (4), wherein the ratio of the peak intensity ($I_{020}$) for plane index (020) to the peak intensity ($I_{-141}$) for plane index (-141), $I_{020}/I_{-141}$ in the X-ray diffraction spectrum of the red colored film is 1.5 or more and 4.5 or less.

(6) The red colored film described in aspect (5), wherein the absolute birefringence of the red colored film at a wavelength of 580 nm is 0 to 0.01.

Effect of the Invention

The α-diketopyrrolopyrrole pigment according to the present invention shows no increase in refractive index after mechanical pulverization of the pigment primary particles, and the red colored film containing the pigment and a pigment carrier has smaller absolute birefringence and smaller optical anisotropy. In addition, the α-diketopyrrolopyrrole pigment less, and thus, the red colored film containing the pigment has less influence by light scattering and has higher contrast ratio.

Further, as the α-diketopyrrolopyrrole pigment according to the present invention has a ratio of the peak intensity ($I_{-141}$) for plane index (-141) to the peak intensity ($I_{111}$) for plane index (111), $I_{-141}/I_{111}$ in the X-ray diffraction spectrum of 1.28 or less, the red colored film has smaller absolute birefringence. For that reason, if a red colored film containing the α-diketopyrrolopyrrole pigment according to the present invention and the pigment carrier is used for a red filter segment for color filter, the color filter obtained shows small view-angle dependence and superior display characteristics as it has high contrast ratio and small absolute birefringence.

Brief Description of the Drawings

Fig. 1 is a powder X-ray diffraction spectrum of a known diketopyrrolopyrrole-based pigment; and
Fig. 2 is an X-ray diffraction spectrum of a red colored coated film of the present invention.

Best Mode of Carrying Out the Invention

First, the α-diketopyrrolopyrrole pigment according to the present invention will be described below.

The α-diketopyrrolopyrrole pigment according to the present invention has the ratio of the peak intensity ($I_{020}$) for plane index (020) to the peak intensity ($I_{-141}$) for plane index (-141) in the X-ray diffraction spectrum, $I_{020}/I_{-141}$ of 0.40 or lower and the ratio of the peak intensity ($I_{-141}$) for plane index (-141) to the peak intensity ($I_{111}$) for plane index (111) in the X-ray diffraction spectrum, $I_{-141}/I_{111}$ of 1.28 or lower.

The alpha form of a diketopyrrolopyrrole pigment (C.I. Pigment Red 254), which is stable form, has the X-ray diffraction pattern wherein there exist peaks in double glancing angles (2θ) of 7.5, 14.9, 17.5, 20.5, 24.7, 25.8, 28.3, 31.0 and 32.2, in which the peak at 28.3 is largest and the peaks at 24.7 and 25.8 were second largest. Respectively, the peak at 7.5 degrees corresponds to plane index (020), showing information about overlapping between crystallites; the peak at 14.9 degrees corresponds to plane index (040); the peak at 24.7 degrees corresponds to plane index (111), showing information about hydrogen-bonding direction; the peak at 25.8 degrees corresponds to plane index (-141), showing information about crystallite-laminating direction; the peak at 28.3 degrees corresponds to plane index (-151), showing information about laminating direction; the peak at 31.0° corresponds to plane index (151), showing information about overlapping in inclined direction; and the peak at 32.2 degrees corresponds to plane index (002).

After studies, the inventors have found that the peak intensity ratio of pigment, $I_{020}$/I-$_{141}$ has a good correlation with the contrast ratio and can be regarded as a value reflecting the particle diameter of the pigment, and that a pigment having smaller peak intensity ratio, $I_{020}/I_{-141}$ is capable of giving a red colored film higher in contrast ratio. Further, the ratio of the peak intensity ($I_{020}$) for plane index (020) to the peak intensity ($I_{-141}$) for plane index (-141), $I_{020}/I_{-141}$ is the ratio of intercrystallite overlapping to intracrystallete overlapping, i.e., a parameter showing the overlapping state of crystallites, and a larger ratio indicates larger intercrystallite overlapping, and a smaller ratio indicates smaller intercrystallite interaction, and thus, it is a factor related to the size of the particles.

In the X-ray diffraction spectrum of the α-diketopyrrolopyrrole pigment according to the present invention, the ratio of the peak intensity ($I_{020}$) for plane index (020) to the peak intensity ($I_{-141}$)for plane index (-141), $I_{02G}/I_{-141}$ is 0.40 or lower. The peak intensity ratio $I_{02G}/I_{-141}$ is more preferably 0.38 or lower to give a pigment having higher contrast. When an α-diketopyrrolopyrrole pigment having a peak intensity ratio, $I_{020}/I_{-141}$ of more than 0.40 is used, the contrast ratio of the resulting red colored film is lower. The peak intensity ratio, $I_{020}/I_{-141}$ is preferably lower, but, when the lower

limit of the peak intensity ratio, $I_{020}/I_{-141}$ of pigments, that is possible to actually produce, is considered, it is preferably 0.15 or higher, more preferably 0.25 or higher.

The diketopyrrolopyrrole pigment is the crystal of diketopyrrolopyrrole molecules with anisotropy in polarizability, and thus, each of the pigment particles is a birefringent substance. In the X-ray diffraction spectrum of the diketopyrrolopyrrole pigment (C.I. Pigment Red 254), the ratio of the peak intensity ($I_{-141}$) for plane index (-141) to the peak intensity ($I_{111}$) for plane index (111), $I_{-141}/I_{111}$ is a parameter showing the ratio of the overlapping in two different directions, the crystallites laminating direction and the hydrogen-bonding direction. After studies, the inventors have found that the peak intensity ratio, $I_{-141}/I_{111}$ had a good correlation with the birefringence of the red colored film if prepared, and also that it was possible to reduce the birefringence of the resulting red colored film, by controlling the peak intensity ratio, $I_{-141}/I_{111}$ in a particular range.

In the X-ray diffraction spectrum of the α-diketopyrrolopyrrole pigment according to the present invention, the ratio of the peak intensity ($I_{-141}$) for plane index (-141) to the peak intensity ($I_{111}$) for plane index (111), $I_{-141}/I_{111}$ is 1.28 or lower. Increase in the peak intensity ratio, $I_{-141}/I_{111}$ of pigment leads to increase in birefringence toward plus direction, and decrease in the peak intensity ratio, $I_{-141}/I_{111}$ of pigment to increase in birefringence toward minus direction, and thus, the resulting color filter, if prepared, has larger view-angle dependence in both cases. In addition, the pigment peak intensity ratio, $I_{-141}/I_{111}$ is preferably 1.00 or higher and 1.28 or lower, more preferably 1.12 or higher and 1.28 or lower. Use of an α-diketopyrrolopyrrole pigment having a peak intensity ratio, $I_{-141}/I_{111}$ of more than 1.28 leads to increase in the absolute value of birefringence in red colored film and increase in view-angle dependence of the color filter when prepared.

The X-ray diffraction spectrum, which is used for identification and analysis of a sample by using the X-ray diffraction intensity and the lattice spacing determined from the scattering angle, can be obtained not only with powder but also with coated film. The X-ray diffraction spectrum of a pigment is obtained by using a powdery pigment as sample and filling it in a glass or metal plate for powder measurement. Alternatively, the X-ray diffraction spectrum of a coated film is determined by measurement of the coated film formed on a substrate such as of glass.

In the present invention, the condition for measuring the X-ray diffraction spectrum of the pigment and the coated film is as follows. The peak intensity in the measured data was determined after peak separation by using peak separation software ProFit.

X-ray diffraction analyzer: "X'pertPRO," manufactured by Philips Electronics Japan,
X-ray-generating device: Cu (sealed tube)
Filter: None
Sampling width: 0.0167° (pigment) or 0.05° (coated film)
Scanning velocity: 0.108°/s (pigment) or 0.0167°/s (coated film)
Tube voltage: 45 kV
Divergence slit: auto (pigment) or 1/8° (coated film)
Tube current: 40 mA
Scanning axis: 2θ or θ (pigment) or 2θ (coated film) (θ = 0.35°)
Light-receiving optical system: X'Celerator (pigment) or 0.27° parallel plates collimator + flat-plate graphite monochrometer (coated film)
Measured angle range: 3 to 50°

The α-diketopyrrolopyrrole pigment is produced, for example, in two steps: a step of synthesizing a crude crystal of a diketopyrrolopyrrole pigment, which is a fine uniform primary particle (hereinafter, referred to as first step) and a step of controlling the crystalline form of the diketopyrrolopyrrole pigment with adjusting the growth of the crude crystal (hereinafter, referred to as second step). Specifically in the first step, crude crystal of a diketopyrrolopyrrole pigment with fine uniform primary particles can be prepared by allowing reaction of a succinic diester with p-chlorobenzonitrile in an inert organic solvent in the presence of a strong base at high temperature, to give an alkali-metal salt of the diketopyrrolopyrrole pigment, and then, adding the alkali-metal salt of the diketopyrrolopyrrole pigment into a protonation medium while it is agitated. In the second step, the control of crystalline form of the diketopyrrolopyrrole pigment can be conducted by mixing and agitating the crude crystal of the diketopyrrolopyrrole pigment obtained in the first step in a medium comprising alcohol in an amount of 80 to 100 wt% and water in an amount of 20 to 0 wt% at low temperature. Hereinafter, the first and second steps will be described in more detail.

(First step)

As described above, the first step is a step of synthesizing the crude crystal of a diketopyrrolopyrrole pigment, which is a fine uniform primary particle. The first step is carried out according to a method similar to that described in JP-A-58-210084, and, as the condition for protonation of the alkali-metal salt of diketopyrrolopyrrole pigment is important,

the protonation condition will be described in detail later. The conditions for protonation include the composition of the medium for conducting protonation, the method of mixing the alkali-metal salt solution of diketopyrrolopyrrole pigment with the protonation medium, the adding method thereof, conditions of temperature and agitation, agitation state during protonation and the like.

The first step of synthesizing the crude crystal of a diketopyrrolopyrrole pigment by a method according to the succinic ester production method includes the steps of first preparing an alkali-metal salt of diketopyrrolopyrrole pigment in reaction of 1 mole of a succinic diester and 2 mole of p-chlorobenzonitrile in an inert organic solvent in the presence of a strong base such as an alkali metal alkoxide at high temperature, and then precipitating the crude crystal of the diketopyrrolopyrrole pigment by protonation of the diketopyrrolopyrrole pigment alkali-metal salt, by means of injecting the obtained solution of the diketopyrrolopyrrole pigment alkali-metal salt that is kept at 70 to 100°C into an alcohol having 1 to 3 carbon atoms, water, an acid or the mixture thereof as the mixture is agitated so that the diketopyrrolopyrrole pigment alkali-metal salt is dispersed instantaneously, in small portions to make the temperature of the dispersed mixture remain at 10°C or lower. As for the reaction ratio of the p-chlorobenzonitrile to the succinic diester, p-chlorobenzonitrile is used basically in an amount of 2 moles with respect to 1 mole of the succinic ester, but use of one raw material in an excess of approximately 10 to 20 mol% to another is effective to increase the yield.

The succinic diester used as a raw material compound in the first step may be a succinic dialkylester, a succinic diarylester, or a succinic monoalkylmonoarylester. Typical examples of the succinic esters include dimethyl succinate, diethyl succinate, dipropyl succinate, diisopropyl succinate, diisobutyl succinate, di-tert-butyl succinate, dipentyl succinate, di-tert-amyl succinate, diphenyl succinate, di-4-chlorophenyl succinate, and the like. A symmetric diester is more preferable than an asymmetric diester, and a branched alkyl group is preferable as the alkyl group. The favorable branched alkyl groups include branched alkyl groups having 3 to 5 carbon atoms such as isopropyl, isobutyl, tert-butyl, and tert-amyl, and the like.

Examples of the strong bases include alkali metals, alkali metal amides, alkali metal hydroxides, alkali metal or alkali-earth metal alkoxides (alcoholates) and the like, and alkali metal alkoxides are preferred. The alkali metal alkoxide used as a strong base may be that prepared in situ or a commercially available product. The alkali metal alkoxide is preferably a sodium or potassium alkoxide derived from a secondary or tertiary alcohol. Primary alcohol-derived alkoxides are unfavorable, because they are more basic and easily cause side reactions. Particularly favorable alkali metal alkoxides are sodium isopropylate, sodium isobutylate, sodium tert-butylate, and sodium tert-amylate. When prepared in situ, it is prepared by melting an alkali metal such as sodium in an alcohol in an amount of 10 to 20 times by weight with respect to alkali metal as it is heated at 100°C or higher and agitating the mixture vigorously for a long period until complete dissolution of sodium. The alkali metal alkoxide is used in an amount of 1 to 4 times by mole, preferably 1.5 to 2 times by mole, with respect to the succinic diester.

The cyclization reaction for synthesizing the crude crystal of the diketopyrrolopyrrole pigment in the first step is carried out in an inert organic solvent. Suitable inert organic solvents include primary to tertiary alcohols having 1 to 10 carbon atoms, glycols, ethers, glycol ethers, aprotic polar solvents, aliphatic or aromatic hydrocarbons, aromatic heterocyclic compounds and the like. Favorable are secondary and tertiary alcohols, and isobutanol, tert-butanol, tert-amyl alcohol and the like are most preferable. Alternatively, a mixture of the alcohol described above and an aromatic hydrocarbon such as toluene may also be used. The amount of the organic solvent used is an amount by which the raw materials for reaction are solubilized to obtain uniformly agetated state, and use of an organic solvent in an amount of 2 to 15 times by weight with respect to the nitrile compound is preferred. An organic solvent amount of twice or less by weight leads to incomplete dissolution of the raw materials, prohibiting sufficient progress of the reaction. The amount of more than 10 times by weight leads to decline of the raw material concentration, decrease in the probability of contact between the succinic diester and the nitrile compound, and consequently deterioration in yield.

When an alcohol is used as the organic solvent, a succinic diester, an alkali metal alkoxide, and an alcohol having the same alkyl chain are preferably used for improvement in yield and recovery of the organic solvent. Particularly preferable is a combination of the compounds having a tert-amyl group: di-tert-amyl succinate, sodium tert-amylate and tert-amyl alcohol.

The cyclization reaction at high temperature is carried out by dissolving a succinic diester, a nitrile compound and a strong base such as an alkali metal alkoxide in an inert organic solvent and heating the mixture while agitated under normal pressure or under some pressure (< 0.2 MPa) at 70 to 120°C, preferably 80 to 105°C for several hours. As the method of adding, it is preferred that the solution in which the succinic diester and the nitrile compound are dissolved in inert organic solvent under heating is added dropwise in small portions into the inert organic solvent in which the alkali metal alkoxide is dissolved under heating. The dissolution temperature of these solutions is preferably in the range of 80 to 105°C for both solutions. The solution containing the heat dissolved succinic diester and nitrile compound in inert organic solvent is added dropwise to the solution of the heat dissolved alkali metal alkoxide in inert organic solvent, and the dropwise addition is preferably performed gradually over a period of 1 to 2 hours at a certain velocity under strong agitation for prevention of side reactions. After dropwise addition, the mixture is agitated additionally under heating, for example at 80 to 100°C for 1 to 5 hours for complete cyclization reaction. It is also effective to add only the

succinic diester dropwise into a solution of the heat dissolved nitrile compound and metal alkoxide in organic solvent. In this case too, dropwise addition is preferably performed gradually over a period of 1 to 2 hours and the mixture after dropwise addition is agitated additionally for 1 to 5 hours.

It is important that the inert organic solvent, the succinic diester, the nitrile compound and the alkali metal alkoxide used in reaction contain water in amounts as low as possible. A water content of 0.2 wt% or more leads to decomposition of the nitrile compound and the generated diketopyrrolopyrrole pigment by a generated strong base such as sodium hydroxide and consequently to decrease in yield.

Cyclization reaction of 1 mole of the succinic diester and 2 moles of the nitrile compound gives an alkali-metal salt of diketopyrrolopyrrole pigment. The diketopyrrolopyrrole pigment alkali-metal salt is in the solution state or in the suspension state containing precipitates after cyclization reaction at 70 to 100°C. The diketopyrrolopyrrole pigment alkali-metal salt in the stabilized solution or suspension state at 70°C to 100°C is brought into contact with a medium containing protons, such as water, alcohol or acid, for protonation, giving the crystal of the diketopyrrolopyrrole pigment. The temperature of the diketopyrrolopyrrole pigment alkali-metal salt when in contact with the proton-containing medium is preferably low for prevention of decomposition of the product, preferably 70 to 80°C for keeping lower the temperature of the mixture with the proton-containing medium. A temperature of 60°C or lower may lead to solidification of the product and the alkali-metal salt by precipitation, making it difficult to discharge the product and prohibiting production of uniform fine particles, even when it is brought into contact with the proton-containing medium after they are solidified. The protonation step is called protolysis. Normally, the diketopyrrolopyrrole pigment alkali-metal salt is protonated as it is mixed sufficiently with a protonation medium such as water, alcohol or acid under strong agitation.

The first step of the present invention is aimed at synthesizing fine uniform primary particles of the crude crystal of a diketopyrrolopyrrole pigment. In the first step, the crystalline form thereof is not particularly limited. The diketopyrrolopyrrole pigment in any crystalline form can be converted into a stable crystalline form by the solvent treatment in the second step. The size and the uniformity of the crude crystal, i.e., primary particle, are important in the first step. The size and the uniformity of the primary particles are influenced significantly by the condition for protonation of the diketopyrrolopyrrole pigment alkali-metal salt. Therefore, the protonation condition, specifically the composition of the medium added, the addition method, the temperature, and the agitation state will be described below in detail.

An alcohol having 1 to 3 carbon atoms and/or water and/or an acid are used as the medium (hereinafter, referred to as protonation medium), to which the diketopyrrolopyrrole pigment alkali-metal salt is added for protonation little by little. The alcohol having 1 to 3 carbon atoms, such as methanol, ethanol, n-propanol or isopropanol, plays a role of a compatibilizer dissolving the inert organic solvent and water for cyclization reaction in each other. The alcohol and water are used at an alcohol: water ratio by weight in the range of 50 : 50 to 0 : 100. The amount of the alcohol is preferably lower as it accelerates crystal growth. The word 'acid' is used as the word of wide range including acidic substances, and examples thereof include acids such as hydrochloric acid, sulfuric acid, acetic acid, formic acid, phosphoric acid and nitric acid; acidic salts such as sodium hydrogen sulfite and potassium hydrogen sulfate; and acidic normal salts such as ammonium chloride, aluminum sulfate and ammonium sulfate, and these compounds accelerate protonation. The amount of the acid used is preferably larger than that needed for complete neutralization of the strong base compound such as alkali metal alkoxide used in the reaction. Normally, it is used in an amount of 1.2 moles to 5 moles with respect to 1 mole of the alkali metal alkoxide. The pH of the system is preferably controlled to 10 or less over the entire course of protonation, more preferably in the acidic range of $1 < pH < 7$. The amount of the protonation medium, a mixture of an alcohol, water, and an acid, should be large enough to a degree that the viscosity is maintained low so as to agitate the suspension for precipitation of the diketopyrrolopyrrole pigment vigorously, and is preferably 3 to 10 times by weight with respect to the inert organic solvent used in cyclization reaction.

The diketopyrrolopyrrole pigment alkali-metal salt is protonated by a method of adding the solution of the diketopyrrolopyrrole pigment alkali-metal salt to a protonation medium. The reverse method of adding a protonation medium to the reaction solution of the diketopyrrolopyrrole pigment alkali-metal salt causes local precipitation and crystal growth of the diketopyrrolopyrrole pigment during dropwise addition, giving particles uneven in size and lower in quality for color filter. Further, the precipitation leads to drastic increase in the viscosity of the suspension, deteriorating the agitational state and easily giving large and uneven particles. Thus, the method of adding the diketopyrrolopyrrole pigment alkali-metal salt to the protonation medium is preferable, because fine and uniform-sized particles can be obtained.

The addition speed of the diketopyrrolopyrrole pigment alkali-metal salt is basically little by little. It is desirable to keep the protonation temperature low in a particular range by adjusting the addition speed. The addition period thereof is roughly 15 minutes to 4 hours. Rapid addition, which leads to lower instantaneous dispersion force, often gives larger primary particles. Because addition of the diketopyrrolopyrrole pigment alkali-metal salt in the heat solution state at 70°C or higher often raises the temperature of the protonation suspension, addition in small portions is preferable for preservation of a certain temperature. Alternatively, elongation of the addition period, which leads to gradually crystal growth of the crude crystal of the diketopyrrolopyrrole pigment previously precipitated, is also unfavorable from the point of uniformity of the primary particles. The most favorable addition period may vary according to the agitational state and

the cooling capacity, but is in the range of 30 minutes to 2 hours.

When the diketopyrrolopyrrole pigment alkali-metal salt is added to the protonation medium, the temperature of the protonation medium is kept preferably at 10°C or lower, more preferably at 5°C or lower during the course of protonation. A protonation temperature of higher than 10°C often results in excessive enlargement of the primary particles and thus, deterioration in contrast. The temperature of the protonation medium is preferably kept at 0°C or lower. Addition of the diketopyrrolopyrrole pigment alkali-metal salt at a high temperature of 70 to 100°C to the protonation medium leads to increase in temperature, and thus, the system should be kept at low temperature for example by means of a device having a sufficient cooling capacity. Use of a large amount of ice is effective for preservation of low temperature and also for adjustment in a particular temperature range.

During addition of the diketopyrrolopyrrole pigment alkali-metal salt to the protonation medium, the diketopyrrolopyrrole pigment alkali-metal salt is added while the protonation medium is agitated. The state while the protonation medium is agitated means a strong agitation state where the added diketopyrrolopyrrole pigment alkali-metal salt is dispersed instantaneously, i.e., the added diketopyrrolopyrrole pigment alkali-metal salt is dispersed uniformly in several seconds, and it is preferably a state agitated under high shearing force. Specifically, the agitation, as expressed by peripheral speed, is at least 2 m/sec or more, preferably 5 to 50 m/sec, and particularly preferably 10 m to 50 m/sec.

The agitation speed may vary according to the size of the agitation blade, but preferably 100 rpm or more. Various kinds of agitation blades including shaft-shaped, anchor-shaped, propeller-shaped, plate-shaped and 2-stage-type blades can be used for agitation. Alternatively, a Maxblend blade superior in agitation efficiency is also effective. Examples of the agitators include agitators at an agitation speed of approximately 0 to 300 rpm for use in common chemical reactions and agitators at a high agitation speed of several thousand rpm such as dissolver, high-speed mixer, and homomixer. Alternatively, it is also very effective to agitate locally at high speed the area where the diketopyrrolopyrrole pigment alkali-metal salt is added, while the entire solution is agitated in combination of a low speed agitator at 100 to 300 rpm and a dissolver-type agitator of high speed agitation.

During protonation of the diketopyrrolopyrrole pigment alkali-metal salt in the first step, the protonation medium may be agitated by circulation by using a water-jet aspirator or ejector. Use of a water-jet aspirator or ejector allows production of fine, uniform-sized crude crystals of the diketopyrrolopyrrole pigment, and thus, a high-quality pigment for color filter after the solvent processing of second step. During circulation of the protonation medium by using a water-jet aspirator or ejector, it is possible to generate high-speed flow of the protonation medium and high shearing force when the diketopyrrolopyrrole pigment alkali-metal salt brought into contact with protonation medium, by placing a previously adjusted protonation medium in a tank and supplying the medium into the water-jet aspirator or ejector by a strong pump.

Use of a water-jet aspirator or ejector allows injection of the diketopyrrolopyrrole pigment alkali-metal salt little by little through a narrow tube to the protonation medium flowing at a pressure of 0.05 to 0.6 MPa in a pipe or tube at high speed and gives very fine crude crystals of the diketopyrrolopyrrole pigment, as a high shearing force is generated in the stream when in contact with the protonation medium such as alcohol, water and/or acid. It is also possible to prepare uniform-sized crude crystals of the diketopyrrolopyrrole pigment, because the protonation is carried out at a constant temperature and a constant pressure throughout the reaction. A glass ejector commercially available from Asahi Seisakusho Co., Ltd. may be used as the water-jet ejector. The ejector is an apparatus generating reduced pressure with water stream in a structure similar to that of aspirator, but has a slightly larger diameter. Use of it allows addition of the diketopyrrolopyrrole pigment alkali-metal salt little by little through the ejector to the medium flowing at high speed by forced high-speed circulation of the protonation medium by a pump and gives fine uniform-sized crude crystals under stabilized application of a high shearing force similar to that by a water-jet aspirator.

Protonation with a water-jet aspirator or ejector does not demand an acid or an acidic substance particularly. The fine uniform primary particles of the crude crystal of the diketopyrrolopyrrole pigment can be obtained even without use of an acid or an acidic substance. However, addition of an acid or an acidic substance is effective in giving finer primary particles of the crude crystal of the diketopyrrolopyrrole pigment, and thus, an acid or an acidic substance is preferably added even when protonation is performed by using a water-jet aspirator or ejector. The system is preferably controlled to a pH of 10 or less, more preferably in the acidic range of $1 < pH < 7$, by addition of an acid or an acidic substance throughout the protonation reaction. During protonation by using a water-jet aspirator or ejector, the temperature of the system is preferably kept at 5°C or lower, more preferably 0°C or lower, for preparation of the fine uniform primary particles of the crude crystal of the diketopyrrolopyrrole pigment.

Protonation of the diketopyrrolopyrrole pigment alkali-metal salt gives a red colored suspension containing the diketopyrrolopyrrole pigment. Most of the protonation medium used in the first step should be removed, because the pigment is agitated under heat in an organic solvent causing crystalline-form transition in the second step of the present invention.

For removal of the protonation medium used in the first step, filtration is carried out using filter or a separation apparatus such as filter press, leaf filter, Nuche, horizontal filter, or continuous centrifugal separator. The filtration is effected efficiently, for example, under applied pressure, reduced pressure, or centrifugal force. After filtration of the

mother liquid, the diketopyrrolopyrrole pigment obtained is washed with an organic solvent such as alcohol or water for removal of impurities. The diketopyrrolopyrrole pigment after filtration is isolated finally as an aqueous or organic-solvent paste containing the pigment in an amount of approximately 10 to 40 wt%.

In the solvent treatment in the second step, the paste of the diketopyrrolopyrrole pigment obtained in the first step may be used as it is, or the paste obtained may be previously processed into powder by drying and pulverization. The paste is dried in a drier such as box drier, paddle drier or reduced-pressure drier normally at a temperature of 50 to 90°C. The pulverization is effected in a pulvelizer such as hammer mill, cutter mill or atomizer. A micron drier, a spin flash drier, or the like allowing simultaneous drying and pulverization may be used instead. Alternatively, freeze drying in a freeze drier gives a powder with smaller aggregation by drying and favorable dispersibility. Use of the paste as it is without drying and pulverization is advantageous, from the points of productivity and cost. Pulverization by using a pulverizer such as hammer mill, cutter mill or atomizer only makes the pigment aggregated during drying into power by mechanical pulverization and does not reduce the size of the primary particles of the pigment.

The solvent treatment in the second step may also be conducted, after the solvent composition of the suspension containing the crude crystal of the diketopyrrolopyrrole pigment in protonation medium reaches to the composition allowing the progression of crystalline transition in the second step by gradually replacing solvent in the suspension formed in a first step to a new solvent to be used in the solvent treatment of the second step in the way where the protonation solvent is removed from the suspension, for example by using an ultrafiltration machine, as the suspension is concentrated, and new solvent is gradually added to the suspension in the amount corresponding to the amount of removed solvent. The method allows processing in the first and second steps continuously without a filtration or drying step, thus providing a production method higher in productivity.

If the crude crystal of the diketopyrrolopyrrole pigment obtained in the first step is filtered, dried and pulverized before solvent treatment, the suspension containing the crude crystals of the diketopyrrolopyrrole pigment may be processed with a resin or a surfactant before drying for prevention of the aggregation by drying. The resin treatment is treatment by using a rosin, an acrylic resin, an styrene acrylic resin or the like, and is effected by adding a solution or emulsion of the resin to the suspension containing the crude crystals of the diketopyrrolopyrrole pigment. The surfactant treatment is carried out, similarly to the resin treatment, by adding the solution or emulsion of a surfactant to the suspension containing the crude crystals of the diketopyrrolopyrrole pigment. The surfactant may be a cationic, anionic, or nonionic surfactant.

The crystalline form of the crude crystal of the diketopyrrolopyrrole pigment obtained in the first step is not particularly limited. In the second step, the pigment in any crystalline form is converted into a stable crystalline form in the solvent treatment of the second step. When the diketopyrrolopyrrole pigment is C.I. Pigment Red 254, the crystalline form of the crude crystal obtained in the first step is mostly beta form. However, in the case of C.I. Pigment Red 254, the crystalline form of the crude crystal obtained in the first step is converted into the stabler alpha form in the solvent treatment, independently of whether it is alpha form, beta form, or a mixture of alpha form and beta form.

The crude crystal of the diketopyrrolopyrrole pigment obtained in the first step including controlled protonation processing is fine primary particles having a diameter, as determined by observation under transmission electron microscope (TEM), of 10 to 60 mm. In particular, when the diketopyrrolopyrrole pigment is C.I. Pigment Red 254, the primary particle size of the crude crystal of the diketopyrrolopyrrole pigment obtained in the first step is very small at a diameter of 10 to 40 nm. Use of a water-jet aspirator or ejector gives crude particles having a diameter of 10 to 30 nm.

(Second step)

The second step is a step of mixing the crude crystal of the diketopyrrolopyrrole pigment obtained in the first step with an organic solvent causing crystalline-form transition under agitation and converting the crude crystal into the stabler crystalline form by controlling crystal growth and formation of the crude crystal.

In the second step, the mixing and agitation treatment in the organic solvent causing crystalline-form transition is performed by dispersing the powder of the crude crystalline of the diketopyrrolopyrrole pigment obtained in the first step or the paste thereof with water or an organic solvent in an organic solvent causing crystalline-form transition and agitating the suspension, and mixing and agitating it for example, at a temperature of -15 to 100°C for 10 minute to dozens of hours. The agitation does not demand particularly high speed, but the entire suspension is preferably placed in the flowing state. Normally, the suspension is agitated at an agitation speed of approximately 100 to 300 rpm.

The organic solvent used in the second step is an organic solvent promoting crystal transition of the diketopyrrolopyrrole pigment. In the present invention, an alcohol having 1 to 4 carbon atoms is used. Typical examples thereof include straight-chain alcohols such as methanol, ethanol, n-propanol and n-butanol; branched alcohols such as isopropyl alcohol, 2-butanol and tert-butanol; ethylene glycol, diethylene glycol, and the like. These alcohols are less toxic and used favorably.

In the second step, the crude crystal of the diketopyrrolopyrrole pigment obtained in the first step is mixed under agitation in a medium containing the alcohol at 80 to 100 wt% and water at 20 to 0 wt%. When the alcohol content in

the medium is less than 80 wt%, there is a phenomenon of no crystal transition or only delayed crystal transition, which is unfavorable. Two or more of alcohols may be contained, but the kind of the alcohols used is preferably smaller from the point of solvent recycling. The temperature for progress of crystal transition may vary according to the kind of the alcohol used, but, when methanol or ethanol is used, crystal transition proceeds rapidly and the growth of particle size occurs easily. Therefore, the temperature is preferably kept in the range of -10 to 5°C. On the other hand, the crystal transition speed is slower in alcohols having 3 or 4 carbon atoms such as isobutyl alcohol and tert-butyl alcohol, and thus, the temperature is preferably kept in the range of 10 to 20°C. The amount of the organic solvent used in the second step is not particularly limited, but preferably 10 to 40 times by weight with respect to the diketopyrrolopyrrole pigment.

It is effective to perform the agitation processing in the organic solvent causing crystalline-form transition, by milling dispersion by using a bead mill such as sand mill or Eiger mill in combination. In such a case, the mechanical shock thereby accelerates the crystal transition. Fine beads having a diameter of 0.3 to 2 mm commonly used for pigment dispersion, such as glass bead, steel bead, zirconia bead, and alumina bead, can be used as the beads used in the bead mill. When a bead mill is used in combination, the resulting pigment has more favorable physical properties in transparency, viscosity stability, dispersion stability, haze and others than those of the pigment treated only by agitation, but is resistant to separation by filtration.

In the mixing agitation treatment in organic solvent in the second step according to the present invention, a small amount of a basic substance may be added for acceleration of the crystal transition. However, because the diketopyrrolopyrrole pigment shows rapid crystal growth when agitated under heat and under alkaline condition, it is difficult to determine the favorable amount and the use method of the basic substance. The basic substance added to the organic solvent during the mixing and agitation treatment is not particularly limited, if it is soluble in the crystal transition-inducing organic solvent. Examples thereof include inorganic basic substances such as sodium hydroxide, potassium hydroxide, calcium hydroxide, barium hydroxide, sodium carbonate, sodium bicarbonate and ammonium carbonate; alkoxides such as sodium methylate, sodium ethylate, sodium tert-butylate and potassium tert-butylate; and amines such as ammonia, methylamine, and dimethylaminopropylamine. The amount added is desirably 25 mol% or less with respect to the diketopyrrolopyrrole pigment. Increase in the amount of the basic substance leads to increase in the crystal transition-inducing effect but it accelerates the crystal growth, which makes it difficult to control the particle size.

When a basic substance was added, the mixture is desirably adjusted to pH 7 or less by addition of an acid such as hydrochloric acid, sulfuric acid or acetic acid after completion of crystal transition. When the alkaline mixture, in which the basic substance is added, is left or processed as it is in the following filtration and purification steps, there is a concern about progress of crystal growth in the steps and thus about generation of a low-quality pigment. It is effective for prevention of deterioration in quality to acidify the mixture followed by carrying out the mixing and agitation treatment in the organic solvent.

In the heating agitation treatment of the second step, it is also possible to accelerate crystal transition by adding the pigment in the stable form additionally. The method is an operation making the crystal form transferring to the desired crystalline form by the template effect based on the crystal with the aimed crystalline form added. When the diketopyrrolopyrrole pigment is C.I. Pigment Red 254, addition of the alpha-form pigment accelerates crystal transition from the beta-form to the alpha-form by the template effect. The amount of the alpha-form pigment with respect to the crude crystal is preferably 5 to 20 wt%. A smaller addition amount leads to weakening of the crystal transition-inducing action, while a larger addition amount is disadvantageous from the points of cost and productivity.

In the second step, the agitation treatment in organic solvent is preferably carried out in the presence of at least one colorant derivative selected from the group consisting of quinacridone derivatives, diketopyrrolopyrrole derivatives, benzisoindole derivatives, anthraquinone derivatives, dianthraquinone derivatives and thiazine indigo derivatives. During the solvent treatment, it is possible to inhibit crystal growth by addition of at least one colorant derivative, i.e., crystal growth inhibitor, selected from the group consisting of quinacridone derivative, diketopyrrolopyrrole derivative, benzisoindole derivative, anthraquinone derivative, dianthraquinone derivative and thiazine indigo derivative. The crystal growth inhibitor often inhibits crystal transition as well. When the colorant derivative is used, care should be given to the kind, the addition amount and the addition timing thereof.

The quinacridone derivative, diketopyrrolopyrrole derivative, benzisoindole derivative, anthraquinone derivative, dianthraquinone derivative or thiazine indigo derivative for use in the present invention is a quinacridone, diketopyrrolopyrrole, benzisoindole, anthraquinone, dianthraquinone or thiazine indigo compound with introduced substituent groups. Typical examples of the colorant derivative structures include, but are not limited to, those represented by the following General Formula (I) having an acidic group such as sulfonic acid or carboxyl group and those having a monovalent to trivalent metal salt or alkyl amine salt of the acidic group; those having a phthalimidomethyl group; those having a triazine ring introduced via-NH-, into which a basic group having tertiary amino group at the terminal thereof is introduced; those represented by the following General Formula (II); those into which a basic group having tertiary amino group at the terminal is introduced via sulfonamide or carbonamide; those represented by the following General Formula (III) into which a benzimidazolone skeleton is introduced; and those represented by General Formula (IV) into which a terminal

aromatic amino group introduced at the terminal. Examples of the monovalent to trivalent metals include sodium, potassium, magnesium, calcium, iron, aluminum and the like. Examples of the alkylamine salts include quaternary ammonium salts of long chain monoalkylamines such as octylamine, laurylamine and stearylamine; quaternary ammonium salts such as palmityltrimethylammonium, dilauryldimethylammonium, and distearyldimethylammonium; and the like.

General formula (I): Q-X

wherein, Q represents a quinacridone residue, diketopyrrolopyrrole residue, benzisoindole residue, anthraquinone residue, dianthraquinone residue or thiazine indigo residue; and X represents-$SO_3H$ or -COOH.

General formula (II):

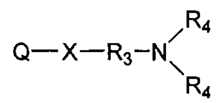

wherein, Q represents a quinacridone residue, diketopyrrolopyrrole residue, benzisoindole residue, anthraquinone residue, dianthraquinone residue or thiazine indigo residue; X represents -$SO_2NH$-, -CONH-, -$CH_2NHCOCH_2$-, -S-, or -NH-; $R_3$ represents an alkylene group having 1 to 4 carbon atoms; and each $R_4$ independently represents an alkyl group having 1 to 4 carbon atoms.

General formula (III):

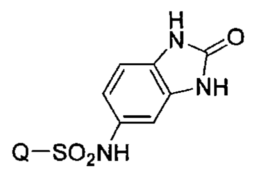

wherein, Q represents a quinacridone residue, diketopyrrolopyrrole residue, benzisoindole residue, anthraquinone residue, dianthraquinone residue or thiazine indigo residue.

General formula (IV):

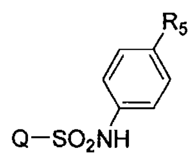

wherein, Q represents a quinacridone residue, diketopyrrolopyrrole residue, benzisoindole residue, anthraquinone residue, dianthraquinone residue or thiazine indigo residue; and $R_5$ represents -$NH_2$ or -$NHCOCH_3$.

The colorant derivative is prepared by a known method such as sulfonation reaction by heating in sulfuric acid or fuming sulfuric acid, phthalimide methylation reaction of dehydration condensation with N-hydroxymethyl phthalimide in sulfuric acid, or sulfonamide-converting reaction of chlorosulfonation by using chlorosulfonic acid and thionyl chloride followed by reacting with an amine such as dimethylaminopropylamine. The number of above substituent group introduced is preferably 1 to 3, most preferably 1 to 2, with respect to one molecule of quinacridone, diketopyrrolopyrrole, benzisoindole, anthraquinone, dianthraquinone or triazine indigo.

The amount of the colorant derivative used is not particularly limited, but is preferably 0.5 to 20 wt%, particularly preferably 2 to 10 wt% with respect to the crude crystal of the diketopyrrolopyrrole. A colorant derivative content of less

than 0.5 wt% results in absence of crystal growth-inhibiting effect, while a colorant derivative content of more than 20 wt% leads to adverse effects on the hue, heat resistance, light stability, water resistance, and sublimation efficiency of the colorant derivative, thus impairs the physical properties as a pigment.

The colorant derivative has an effect to inhibit crystal growth of the diketopyrrolopyrrole pigment. It is required to the colorant derivative that it is adsorbed on the pigment surface efficiently and not desorbed easily therefrom to exhibit the inhibitory action to crystal growth. Thus, the colorant derivative often has the chemical structure partially identical with that of the pigment. Generally for that reason, a colorant derivative having a diketopyrrolopyrrole or quinacridone structure is effective when the diketopyrrolopyrrole pigment is prepared. In addition, colorant derivatives with a phthalimidomethyl group have the largest activity in inhibiting crystal growth among the colorant derivatives above.

The diketopyrrolopyrrole pigment obtained by the method is processed for removal of the organic solvent by means of a filter or a separation apparatus, such as filter press, leaf filter, Nuche, horizontal filter-plate filtration machine or continuous centrifugal separator, washing with water or redispersion in water, and filtering again to isolate as an aqueous paste in which the organic solvent is replaced with water. The aqueous paste obtained is then dried and pulverized into the final shape of powdery pigment. The drying is effected in a drier such as box drier, paddle drier or reduced-pressure drier normally at 50 to 90°C. The pulverization is performed in a pulvelizer such as hammer mill, cutter mill or atomizer. A micron drier, a spin flash drier or the like allowing simultaneous drying and pulverization may be used instead. Alternatively, by a low-temperature vacuum drying such as freeze drying powder with smaller aggregation by drying and favorable dispersibility is obtained. Pulverization using a pulverizer such as hammer mill, cutter mill or atomizer only makes the aggregated pigment during drying into power by mechanical pulverization but does not reduce the size of the primary particles of the pigment.

The diketopyrrolopyrrole pigment obtained may be processed additionally with a resin or a surfactant for preventing aggregation of the pigment at drying. The resin treatment is processing with a resin such as rosin, acrylic resin, or styrene acrylic resin, and performed by addition of the solution or emulsion of such a resin to the suspension containing the diketopyrrolopyrrole pigment. Similarly to resin treatment, the surfactant treatment is performed by adding a surfactant solution or emulsion to the suspension containing the crude crystals of the diketopyrrolopyrrole pigment. The surfactant for use may be any one of cationic, anionic and nonionic surfactants.

The $\alpha$-diketopyrrolopyrrole pigment of the present invention produced by the method described above has a stable crystalline form. When the diketopyrrolopyrrole pigment is C.I. Pigment Red 254, the stable crystalline form is alpha form. The stable alpha form pigment is useful in the color filter application, but the beta-form pigment is not used for color filter because of its low heat resistance. The crystalline form (alpha or beta form) of C.I. Pigment Red 254 pigment can be distinguished by X-ray diffraction. The alpha form pigment has peaks at double glancing angles ($2\theta$) of 7.5, 14.9, 17.5, 20.5, 24.7, 25.8, 28.3, 31.0 and 32.2 and an X-ray diffraction pattern wherein the peak at 28.3 is highest and the peaks at 24.7 and 25.8 are second largest. On the other hand the beta-form pigment has peaks at double glancing angles ($2\theta$) of 5.8, 11.8, 13.5, 14.8, 17.7, 18.2, 23.4, 24.4, 27.2 and 29.5 and an X-ray diffraction pattern wherein the peak at 27.2 is highest and the other peaks are lower. The alpha and beta forms are distinguished mainly by comparing the intensities of the peaks at double glancing angles ($2\theta$) of 28.3 and 27.2. When a pigment has the two peaks, it is a mixed crystal or mixture of alpha and beta forms. The $\alpha$-diketopyrrolopyrrole pigment of the present invention may contain the beta form pigment in the form of mixed crystal or mixture in the range that does not impair the advantageous effects of the present invention.

The $\alpha$-diketopyrrolopyrrole pigment of the present invention preferably has an average primary particle diameter of 40 nm or less, more preferably 10 nm or more and 35 nm or less. The average primary particle diameter is the diameter of a pigment particle of the minimum unit. The average primary particle diameter can be determined, for example, by disintegrating the obtained powder pigment simply by addition of an organic solvent followed by observing the particles under transmission electron microscope (TEM), analyzing the obtained image, and calculating the average of the particle diameters. A diketopyrrolopyrrole pigment having an average primary particle diameter of more than 40 nm causes strong light scattering. It makes difficult to prepare red colored film containing the pigment with a high-contrast. The $\alpha$-diketopyrrolopyrrole pigment of the present invention has a spherical or cubic, almost rectangular shape, when the particle is observed under TEM (transmission electron microscope).

Hereinafter, the coloring composition of the present invention will be described.

The coloring composition of the present invention contains an $\alpha$-diketopyrrolopyrrole pigment of the present invention and a carrier. The pigment carrier is normally constituted by a resin, its precursor or a mixture thereof, and it is preferable that a pigment carrier effective in dispersibility the diketopyrrolopyrrole pigment and dispersion stability of the diketopyrrolopyrrole pigment is selected. The resin includes thermosetting resins, thermoplastic resins and active energy ray-curable resins, and the precursor of the resin includes monomers, dimers, trimers, oligomers, etc. which are cured by irradiation with active energy rays to form the same coating film as the film formed by the resin. These may be used independently or as a mixture of two or more thereof. The pigment carrier is used in an amount of preferably from 50 to 700 parts by weight, more preferably from 100 to 400 parts by weight with respect to 100 parts by weight of the diketopyrrolopyrrole pigment.

In the case of producing a color filter by using the coloring composition, the resin is preferably a transparent resin having a transmittance of 80% or more, preferably 95% or more, in the every wavelength region of from 400 to 700nm in visible light region. In addition, since heating processing at a high temperature is to be conducted in the post-step in producing color filters, for example, in forming transparent electrodes or orientated film, it is necessary to use a resin having good heat resistance.

Examples of the thermoplastic resin include a butyral resin, styrene-maleic acid copolymer, chlorinated polyethylene, chlorinated polypropylene, polyvinyl chloride, vinyl chloride-vinyl acetate copolymer, polyvinyl acetate, polyurethane series resin, polyester resin, acrylic resin, alkyd resin, polystyrene resin, polyamide resin, rubber series resin, cyclized rubber series resin, celluloses, polyethylene (HDPE and LDPE), polybutadiene, polyimide resin, etc. Examples of the thermosetting resin include an epoxy resin, benzoguanamine resin, rosin-modified maleic acid resin, rosin-modified fumaric acid resin, melamine resin, urea resin, phenol resin, etc.

As the active energy ray-curable resin, those resins can be used which are formed by introducing a photo-crosslinkable group such as a (meth)acrylic compound or cinnamic acid via an isocyanato group, an aldehydo group or an epoxy group into a polymer having a reactive substituent such as a hydroxyl group, a carboxyl group or an amino group. Also, polymers obtained by half-esterifying a linear polymer containing acid anhydride, such as a styrene-maleic anhydride copolymer or an alpha-olefin-maleic anhydride copolymer, with a (meth)acrylic compound having a hydroxyl group such as hydroxyalkyl (meth)acrylate can be used.

As the precursor monomer and oligomer of the resin, there are illustrated, for example, various acrylic acid esters and methacrylic acid esters such as 2-hydroxyethyl (meth)acrylate, 2-hydroxypropyl (meth)acrylate, cyclohexyl (meth)acrylate, polyethylene glycol di(meth)acrylate, pentaerythritol tri(meth)acrylate, dipentaerythritol hexa(meth)acrylate, tricyclodecanyl (meth)acrylate and caprolactone adduct of dipentaerythritol hexa(meth)acrylate; acrylic acid; methacrylic acid; (meth)acrylamide; N-hydroxymethyl(meth)acrylamide; styrene; vinyl acetate; acrylonitrile; melamine (meth)acrylate; and epoxy (meth)acrylate prepolymer.

When the coloring composition is curable by irradiation with UV rays, a photo polymerization initiator is added to the composition. As the photo polymerization initiator, any of conventionally used photo polymerization initiators may be used. To specifically illustrate the photo polymerization initiator, there are illustrated, for example, acetophenone series photo polymerization initiators such as 4-phenoxydichloroacetophenone, 4-t-butyl-dichloroacetophenone, diethoxyacetophenone, 1-(4-isopropylphenyl)-2-hydroxy-2-methylpropan-1-one, 1-hydroxycyclohexyl phenyl ketone, 2-benzyl-2-dimethylamino-1-(4-morpholinophenyl)-butan-1-one, 2-methyl-1-[4-(methylthio)phenyl]-2-morpholino-propan-1-one; benzoin series photo polymerization initiators such as benzoin, benzoin methyl ether, benzoin ethyl ether, benzoin isopropyl ether and benzyldimethylketal; benzophenone series photo polymerization initiators such as benzophenone, benzoylbenzoic acid, methyl benzoylbenzoate, 4-phenylbenzophenone, hydroxybenzophenone, acrylated benzophenone and 4-benzoyl-4'-methyldiphenylsulfide; thioxanthone series photo polymerization initiators such as thioxanthone, 2-chlorothioxanthone, 2-methylthioxanthone, isopropylthioxanthone and 2,4-diisopropylthioxanthone; triazine series photo polymerization initiators such as 2,4,6-trichloro-s-triazine, 2-phenyl-4,6-bis(trichloromethyl)-s-triazine, 2-(p-methoxyphenyl)-4,6-bis(trichloromethyl)-s-triazine, 2-(p-tolyl)-4,6-bis(trichloromethyl)-s-triazine, 2-piperonyl-4,6-bis(trichloromethyl)-s-triazine, 2,4-bis(trichloromethyl)-6-styryl-s-triazine, 2-(naphth-1-yl)-4,6-bis(trichloromethyl)-s-triazine, 2-(4-methoxy-naphth-1-yl)-4,6-bis(trichloromethyl)-s-triazine, 2,4-trichloromethyl-(piperonyl)-6-triazine and 2,4-trichloromethyl(4'-methoxystyryl)-6-triazine; borate series photopolymerization initiators; carbazole series photopolymerization initiators; and imidazole series photopolymerization initiators. The photopolymerization initiator is used in an amount of preferably from 5 to 150 parts by weight with respect to 100 parts by weight of the dichlorodiketopyrrolopyrrole pigment.

The abovementioned photo polymerization initiators may be used independently or as a mixture of two or more thereof. It is also possible to use them in combination with sensitizers of compounds such as an $\alpha$-acyloxy ester, acylphosphine oxide, methylphenyl glyoxylate, benzyl, 9,10-phenanthrenequinone, camphorquinone, ethylanthraquinone, 4,4'-diethylisophthalo-phenone, 3,3',4,4'-tetra(t-butylperoxycarbonyl)-benzophenone, 4,4'-diethylaminobenzophenone, etc. The sensitizers are used in an amount of preferably from 0.1 to 150 parts by weight with respect to 100 parts by weight of the photo polymerization initiator.

Solvent may be used in the coloring composition in order to sufficiently disperse the pigment in the carrier so as to uniformly coat it on a substrate. As the solvent, there are illustrated, for example, cyclohexanone, ethyl cellosolve acetate, butyl cellosolve acetate, 1-methoxy-2-propyl acetate, diethylene glycol dimethyl ether, ethylbenzene, ethylene glycol diethyl ether, xylene, ethyl cellosolve, methyl n-amyl ketone, propylene glycol monomethyl ether, toluene, methyl ethyl ketone, ethyl acetate, methanol, ethanol, isopropyl alcohol, butanol, isobutyl ketone, petroleum series solvents, etc. These may be used independently or as a mixture thereof. The solvents are used in an amount of preferably from 500 to 4,000 parts by weight with respect to 100 parts by weight of the dichlorodiketopyrrolopyrrole pigment.

Various dispersing means such as a three-roll mill, two-roll mill, sand mill or kneader can be used for dispersing the $\alpha$-diketopyrrolopyrrole pigment of the present invention in a pigment carrier. In order to facilitate this dispersing procedure, dispersing aids such as various surfactants and dye derivatives may be added thereto. Use of the dispersing aid serves to form a coloring composition containing therein a well-dispersed pigment and preventing reagglomeration

of the dispersed pigment particles.

The coloring composition of the present invention may contain, as needed, various additives such as red pigments other than the α-diketopyrrolopyrrole pigment of the present invention, yellow pigments, dyes, antioxidants, polymerization inhibitors, leveling agents, moisturizers, viscosity improvers, antiseptic substances, antibacterial agents, surfactants, anti-blocking agents, ultraviolet absorbents, infrared absorbents, fillers and conductive materials.

For production of a coloring composition such as printing ink or colored resist, bulky particles of 5 μm or more, preferably 1 μm or more, and still more preferably 0.5 μm or more and dust contaminants are preferably removed by means of centrifuge, sintered filter or membrane filter.

Hereinafter, the red colored film of the present invention will be described.

The red colored film of the present invention is a film containing the α-diketopyrrolopyrrole pigment of the present invention and a pigment carrier, and can be formed on a substrate, for example, by a method of coating the coloring composition of the present invention on a substrate, a method of immersing the substrate in the coloring composition of the present invention, a method of spraying the coloring composition of the present invention on the substrate, an inkjet method, or the like. The coloring composition of the present invention can be coated, for example, by means of a spin coater, a bar coater, a blade coater, a roll coater, a die coater or a screen printing machine. If the coloring composition of the present invention contains a solvent, the coated film is dried by air drying, reflux drying or vacuum drying for removal of the solvent and production of the film. The red colored film formed may be hardened additionally for example by baking (post-baking) and/or active energy ray irradiation. If baking is used for hardening, the coloring composition of the present invention may contain a known material that hardens the coloring composition under heat. The baking temperature may be determined according to the material used. Alternatively if active energy ray irradiation is used for hardening, the coloring composition of the present invention may contain a known material that hardens the coloring composition by active energy ray, and the irradiation condition may be determined according to the material used.

The red colored film of the present invention has the ratio of the peak intensity ($I_{020}$) for plane index (020) to the peak intensity ($I_{-141}$) for plane index (-141), $I_{020}/I_{-141}$ of preferably 1.5 or more and 4.5 or less, more preferably 2.0 or more and 4.0 or less in the X-ray diffraction spectrum. Compared to the X-ray diffraction spectrum of the pigment, the peak intensity ($I_{020}$) for plane index (020) is detected more intensely than the peak intensity ($I_{-141}$) for plane index (-141) in the X-ray diffraction spectrum of the coated film, indicating that the pigment is more oriented in the coated film. The X-ray peak intensity ratio $I_{020}/I_{-141}$ of coated film has a relationship with the birefringence of the coated film. A coated film having the X-ray peak intensity ratio $I_{020}/I_{-141}$ of less than 1.5 has increased birefringence toward the plus direction and thus larger view-angle dependence, while a coated film having an intensity ratio of more than 4.5 has increased birefringence in the minus direction and thus larger view-angle dependence. Thus, a red colored film having a peak intensity ratio $I_{020}/I_{-141}$ in X-ray diffraction spectrum of less than 1.5 or more than 4.5 shows larger view-angle dependence and reduced visibility from the inclined direction, when used as a red filter segment of color filter.

In the X-ray diffraction spectrum of a red colored film containing the diketopyrrolopyrrole pigment, the rotation angle of the aromatic moiety of the diketopyrrolopyrrole pigment exerts an influence on the intensities in the hydrogen-bonding direction and the laminating direction of the X-ray diffraction (see Acta Cryst. (1993). B49, 1056-1060), and thus, the dimension thereof should be adjusted, based on the powder X-ray diffraction spectrum of the diketopyrrolopyrrole pigment.

The powder X-ray diffraction spectrum of a known diketopyrrolopyrrole pigment (Irgafor Red B-CF, manufactured by Ciba Specialty Chemicals) is shown in Fig. 1. Alternatively, the X-ray diffraction spectrum of the coated film formed using a coloring composition of the present invention (Example 2) is shown in Fig. 2. Comparison of the Figs. 1 and 2 shows that there is some difference in appearance of peak intensity but no difference in the double glancing angles (2θ) where the peaks are detected. In Fig. 2, the peak intensity for plane index (-141) is approximately 25.8°, while the peak intensity for plane index (020) is approximately 7.5°. In Fig. 2, the ratio of the peak intensity ($I_{020}$) for plane index (020) to the peak intensity ($I_{-141}$) for plane index (-141), $I_{020}/I_{-141}$ is 2.64. On the other hand in Fig. 2, the peak intensity ratio $I_{-141}/I_{111}$ is 1.56.

The view-angle dependence of liquid crystal display is also influenced by the retardation (product of birefringence and film thickness) of the filter segments in various colors for the color filter. Thus, wide-view angle liquid crystal displays, such as liquid crystal display with a view angle-expanding film using TN liquid crystal and in-plane switching (IPS) liquid crystal display, demand a color filter having of low-retardation filter segments in various colors. The retardation, product of birefringence and film thickness, can be reduced by lowering the film thickness of the filter segment. However, there is restriction to the film thickness of filter segment. Thus for reduction of the color filter retardation, the absolute value of the birefringence of the colored film should be reduced. Here, the view-angle dependence as used herein means that, when an image on the screen of a liquid crystal display is seen perpendicularly to the front face (90°) or from an inclined direction, it is observed differently, and the image seen in the inclined direction shows image quality-deteriorating phenomena such as improper color registration, cloudiness, dull focus, glistening and drastic decrease in brightness, and such phenomena are amplified as the angle to the screen becomes more inclined. The view-angle dependence is

considered to be small, if the degradative phenomena do not occur at shallower angle.

For that reason, the red colored film of the present invention preferably has an absolute birefringence at 580 nm of 0 to 0.01. A red colored film having an absolute birefringence at 580 nm of more than 0.01 has larger view-angle dependence, when used as a red filter segment for color filter. Alternatively, a red colored film having an absolute birefringence at 580 nm of 0 to 0.01 has small view-angle dependence and is more visible from inclined direction. The birefringence $\Delta n$ at 580 nm is a value as defined below that can be determined by using a spectroscopic ellipsometer.

Birefringence

$$\text{Birefringence } \Delta n = n_{xy} - n_z$$

$n_{xy}$: Refractive index when the vibration direction of the light at 580 nm is in parallel with the surface of the thin film
$n_z$: Refractive index when the vibration direction of the light at 580 nm is perpendicular to the surface of the thin film

The red colored film according to the present invention is favorable as a red filter segment for color filter. A common color filter has a transparent substrate and at least one red filter segment, at least one green filter segment, and at least one blue filter segment formed thereon, and each color filter segment is preferably separated by a black matrix.

The substrate on which the coloring composition of the present invention is applied is preferably a transparent substrate, and examples thereof include glass plates such as of soda lime glass, low-alkali borosilicate glass, and nonalkali aluminoborosilicate glass; resin plates such as of polycarbonate, polymethyl methacrylate, and polyethylene terephthalate. Transparent electrodes such as of indium oxide, tin oxide and the like may be formed on the surface of the substrate such as glass plate or resin plate for operation of the liquid crystal after paneling. The dry film thickness of the filter segment in each color or the black matrix is preferably 0.2 to 4 μm.

The filter segment in each color is formed, for example, by a photolithographic method, a printing method, an inkjet method or the like. In particular, the photolithographic and inkjet methods are preferred. The filter segment in each color is formed by the photolithographic method in the following manner: Specifically, a coloring composition prepared as a solvent development-type or alkali development-type colored resist is applied on a transparent substrate by an application method such as spray coating, spin coating, slit coating or roll coating, at a dry film thickness of 0.2 to 4 μm. The film is dried as needed, and exposed to ultraviolet ray through a mask having a predetermined pattern that is installed in contact or not in contact with the film. The film is then immersed in a solvent or an alkaline developing solution or a developing solution is sprayed on the film with a spray for forming a desired pattern by removal of the unhardened regions, to give a filter segment in each color. The film may be heated additionally for accelerating polymerization of the colored resist.

On development, an aqueous inorganic alkaline solution, for example containing sodium carbonate or sodium hydroxide, is used as the alkaline developing solution, or an aqueous organic alkaline solution, for example containing dimethylbenzylamine, triethanolamine, tetramethylammonium hydroxide or choline, may also be used. The developing solution may contain an antifoamer or a surfactant additionally. Applicable development methods include shower developing method, spray developing method, dip (immersion) developing method, paddle (liquid-pouring) developing method, and the like.

For improving the ultraviolet exposure sensitivity, after the colored resist was coated and dried, the resist film formed may be treated with a water-soluble or alkali-soluble resin such as 77 polyvinylalcohol or a water-soluble acrylic resin to form a film thereon for preventing polymerization inhibition by oxygen and then exposed to ultraviolet ray.

Alternatively in the case of the inkjet method, the filter segment is formed by ejecting a coloring composition prepared as inkjet ink into the regions divided by the black matrix on a black matrix-carrying substrate by means of an inkjet ejector.

The black matrix can be prepared on the substrate, for example, by a photolithographic patterning method of coating, exposing and developing a radical-polymerization black resist, a printing method of printing black ink, or a vapor deposition method of vapor-depositing a metal and then etching the resultant film.

## EXAMPLES

Hereinafter, the present invention will be described more specifically with reference to Examples. Part and % in Examples and Comparative Examples respectively mean wt parts and wt%. The primary particle diameter of the pigment is a particle diameter (nm), as determined by observation under transmission electron microscope (TEM). The X-ray diffraction spectrum of each pigment produced was measured using "X'PertPRO" manufactured by Philips Electronics Japan; the detected peaks were all separated with peak separation software, ProFit; the intensities of the peaks at 7.5° (plane index (020)), 25.8° (plane index (-141)) and 24.7° (plane index (111)) were determined; and the peak

intensity ratios $I_{020}/I_{-141}$ and $I_{-141}/I_{111}$ were calculated from these value.
In Examples and Comparative Examples, the colorant derivatives represented by the following Formulae (V), (VI), (VII) and (VIII) were used as the colorant derivatives.

Formula (V):

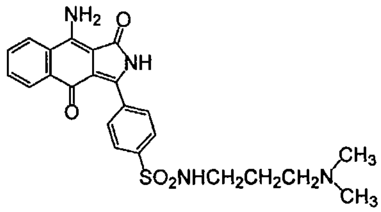

Formula (VI):

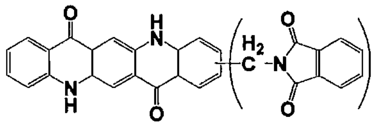

Formula (VII):

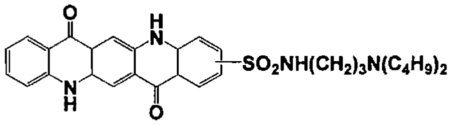

Formula (VIII):

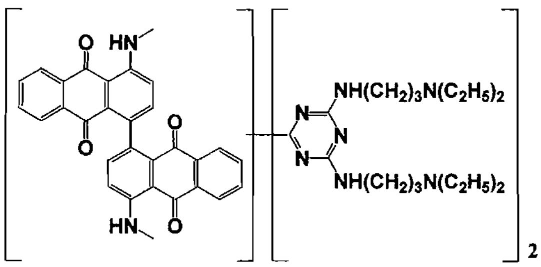

Example 1

(First step)

200 g of tert-amyl alcohol previously dehydrated with molecular sieve and 140 g of sodium tert-amyl alkoxide were placed in a 1-L stainless steel reaction container equipped with a reflux condenser under nitrogen environment, and the mixture was heated to 100°C under agitation, to give an alcoholate solution.
Separately, 120 g of tert-amyl alcohol previously dehydrated with molecular sieve, 88 g of diisopropyl succinate and 100 g of p-chlorobenzonitrile were placed in a 500-ml glass flask, and the mixture was heated to homogeneity to 90°C under agitation, to give a solution of the mixture thereof. The heated mixture solution was added dropwise to the alcoholate solution heated at 100°C gradually at a constant speed over 2 hours, while the mixture was agitated vigorously. After dropwise addition, the mixture was heated and agitated additionally at 90°C for 2 hours, to give a diketopyrrolopyrrole

pigment alkali-metal salt solution.

Separately, 600 g of methanol, 600 g of water and 117 g of acetic acid were placed and cooled to -10°C in a 3-Ljacketted glass reaction container. The diketopyrrolopyrrole pigment alkali-metal salt solution previously obtained at 90°C was added in small portions to the cooled mixture, which was agitated with a shear disk having a diameter of 10 cm and revolving at 1,000 rpm in a high-speed agitation disperser. Then, the diketopyrrolopyrrole pigment alkali-metal salt solution at 90°C was added thereto little by little over approximately 60 minutes, while the mixture of methanol, acetic acid and water was kept consistently at a temperature of 0°C or lower by cooling with a refrigerant and also while the addition speed thereof was adjusted. After addition of the entire amount, dark red crystals were precipitated, giving dark red suspension. The pH of the suspension was 6.2.

(Second step)

The dark red suspension thus obtained above was filtered through a Nuche filter at 5°C, and 300 g of methanol and 1,000 ml of water previously cooled to 10°C were poured thereon for washing. The red paste obtained was redispersed in a mixture of 400 g of methanol and 400 g of water; the mixture is filtered again through a Nuche filter, to give an aqueous paste of the crude crystal of the diketopyrrolopyrrole pigment. The aqueous paste of the crude crystal was then dried in a box drier at 80°C for 24 hours, and the dry aggregate was pulverized and processed into powder by using a hammer mill. The crystalline form of the crude crystal was a mixture of alpha and beta forms.

Subsequently, 1500 g of isobutyl alcohol and 5.6 g of 25% aqueous caustic soda solution were placed and cooled to 10°C in a 3-L reaction container. The powder of the crude crystalline diketopyrrolopyrrole pigment obtained above was added thereto, and the mixture was agitated at 10°C for 6 hours. Then, 4.0 g of 80% acetic acid was added to reduce the pH of the mixture to 7 or less. The mixture was filtered through a Nuche filter; the solid was washed with 1,000 g of cold methanol at 10°C and then with 1,000 ml of water by sprinkling.

The red paste obtained was redispersed in 3,000 ml of water at 5°C; a colorant derivative acetic acid solution containing 11 g of the colorant derivative represented by the Formula (V) above (colorant derivative (V)), 4 g of 80% acetic acid and 200 g of water was added to the dispersion under agitation; the mixture was agitated at 10°C or lower for 1 hour, and the pH thereof was adjusted to 10 with 25% aqueous caustic soda solution. The mixture was filtered again through a Nuche filter, and the cake was washed with 1,000 ml of water by sprinkling, to give an aqueous paste of the fine diketopyrrolopyrrole pigment. The aqueous paste of the fine diketopyrrolopyrrole pigment was dried in a box drier at 80°C for 24 hours, and the dry aggregate was pulverized and processed into powder by using a hammer mill, to give a fine diketopyrrolopyrrole pigment. The fine-particle diketopyrrolopyrrole pigment obtained was C.I. Pigment Red 254 having an alpha-crystalline form, and the primary particle, as determined by TEM observation, was a round particle having a diameter of 20 to 40 nm. The yield amount was 98.6 g, and the yield was 76.0%.

Example 2

(First step)

450 g of tert-amyl alcohol previously dehydrated with molecular sieve and 30 g of small cubes of metal sodium were placed in 1-L stainless steel reaction container equipped with a reflux condenser under nitrogen environment, and the mixture was heated to 90°C. The mixture was heated to 100°C or higher after 1 hour; the mixture was agitated additionally for 10 hours under reflux while the melted metal sodium was agitated vigorously until the metal sodium was dissolved, to give an alcoholate solution.

Separately, 120 g of tert-amyl alcohol previously dehydrated with molecular sieve, 88 g of diisopropyl succinate and 100 g of p-chlorobenzonitrile were placed in a 500-ml glass flask, and the mixture was heated to homogeneity to 90°C under agitation, to give a solution of the mixture thereof. The heated mixture solution was added dropwise to the alcoholate solution heated at 100°C gradually at a constant speed, while the mixture was agitated vigorously over 2 hours. After dropwise addition, the mixture was heated and agitated additionally at 90°C for 2 hours, to give a diketopyrrolopyrrole pigment alkali-metal salt solution.

Further, 600 g of methanol, 600 g of water and 304 g of acetic acid were placed and cooled to -10°C in a 3-L jacketted glass reaction container. The obtained diketopyrrolopyrrole pigment alkali-metal salt solution previously cooled at 75°C was added in small portions to the cooled mixture, which was agitated with a shear disk having a diameter of 8 cm and revolving at 4,000 rpm in a high-speed agitation disperser. Then, the diketopyrrolopyrrole pigment alkali-metal salt solution at 75°C was added thereto little by little over approximately 120 minutes, while the mixture of methanol, acetic acid and water was kept consistently at a temperature of -5°C or lower by cooling with a refrigerant and also while the addition speed thereof was adjusted. After addition of the entire amount, dark red crystals were precipitated, giving dark red suspension. The pH of the suspension was 4.8.

(Second step)

The dark red suspension thus obtained above was filtered through a Nuche filter at 5°C, and 300 g of methanol and 1,000 ml of water previously cooled to 0°C were sprinkled thereon for washing. The solid matter content of the red paste obtained was 21.5%. The paste was redispersed in 3,550 g of methanol previously cooled to 0°C, to give a suspension having a methanol concentration of approximately 90%. The suspension was agitated at 5°C for 3 hours for crystal transition. The suspension is then filtered through a Nuche filter rapidly, and the cake was washed with 1,000 ml of water previously cooled to 5°C. A small amount of it was filtered, dried and then subjected to analysis by X-ray diffraction and TERM, showing that the crystalline form is alpha form and the particle is a round particle having a diameter of 20 to 40 nm. Further, the red paste obtained was redispersed in 3,000 ml of water; a colorant derivative acetic acid solution containing 11 g of the colorant derivative (V), 4 g of 80% acetic acid, and 200 g of water was added thereto under agitation; the mixture was agitated at 10°C or lower for 1 hour and adjusted to pH 10 with 25% aqueous caustic soda solution. The mixture was filtered again through a Nuche filter, and the cake was washed with 1,000 ml of water by sprinkling, to give an aqueous paste of fine diketopyrrolopyrrole pigment. The aqueous paste of the fine diketopyrrolopyrrole pigment was dried in a box drier at 80°C for 24 hours, and the dry aggregate was pulverized and processed into powder by using a hammer mill, to give a fine diketopyrrolopyrrole pigment.

The fine diketopyrrolopyrrole pigment obtained was C.I. Pigment Red 254 having an alpha-crystalline form, and the primary particle, as determined by TEM observation, was a round particle having a diameter of 20 to 40 nm. The yield amount was 106.6 g, and the yield was 81.0%.

Example 3

(First step)

200 g of tert-amyl alcohol previously dehydrated with molecular sieve and 140 g of sodium tert-amyl alkoxide were placed in a 1-L stainless steel reaction container equipped with a reflux condenser under nitrogen environment, and the mixture was heated to 100°C under agitation, to give an alcoholate solution.

Separately, 120 g of tert-amyl alcohol, 88 g of diisopropyl succinate and 100 g of p-chlorobenzonitrile were placed in a 500-ml glass flask, and the mixture was heated to homogeneity to 90°C under agitation, to give a solution of the mixture thereof. The heated mixture solution was added dropwise to the alcoholate solution heated at 100°C gradually at a constant speed, while the mixture was agitated vigorously over 2 hours. After dropwise addition, the mixture was heated and agitated additionally at 90°C for 1 hour, to give a diketopyrrolopyrrole pigment alkali-metal salt solution.

Separately, 3,000 g of ice, 2,000 g of water and 300 g of 80% acetic acid were placed in a 10-L reaction container; and the cold aqueous acetic acid was circulated by a circulation-type aspirator driven by a pump. The hot diketopyrrolopyrrole pigment alkali-metal salt solution at 80°C was suctioned into the suction hole of the aspirator, to give a dark red suspension containing red crystals precipitated.

(Second step)

Afine diketopyrrolopyrrole pigment was prepared, in a similar manner to the second step of Example 2. The fine diketopyrrolopyrrole pigment obtained was C.I. Pigment Red 254 having the alpha-crystalline form, and the primary particle, as determined by TEM observation, was a round particle having a diameter of 10 to 30 nm. The yield amount in the second step was 105.6 g, and the yield was 80.2%.

Example 4

81 Parts of the crude crystal of the diketopyrrolopyrrole pigment obtained in the second step of Example 1 in the mixed alpha and beta forms, 9 parts of the colorant derivative (V), 900 parts of sodium chloride, and 110 parts of diethylene glycol were placed in a "One-gallon Kneader" (manufactured by Inoue Manufacturing) and kneaded for 15 hours. Then, the kneaded mixture was poured into hot water; the mixture was agitated while heated to approximately 80°C for one hour into the slurry state; the slurry was filtered; the resulting cake was washed with water for removal of sodium chloride and diethylene glycol, and then dried at 80°C for an entire day, pulverized, to give 87 parts of a fine diketopyrrolopyrrole pigment. The fine diketopyrrolopyrrole pigment obtained was C.I. Pigment Red 254 having the alpha-crystalline form, and the primary particle, as determined by TEM observation, is a round particle having a diameter of 10 to 30 nm.

Example 5

(First step)

200 g of tert-amyl alcohol previously dehydrated with molecular sieve and 140 g of sodium tert-amyl alkoxide were placed in a 1-L stainless steel reaction container equipped with a reflux condenser under nitrogen environment, and the mixture was heated to 100°C under agitation, to give an alcoholate solution.

Separately, 120 g of tert-amyl alcohol previously dehydrated with molecular sieve, 88 g of diisopropyl succinate and 100 g of p-chlorobenzonitrile were placed in a 500-ml glass flask, and the mixture was heated to homogeneity to 90°C under agitation, to give a solution of the mixture thereof. The heated mixture solution was added dropwise to the alcoholate solution heated at 100°C gradually at a constant speed, while the mixture was agitated vigorously over 2 hours. After dropwise addition, the mixture was heated and agitated additionally at 90°C for 2 hours, to give a diketopyrrolopyrrole pigment alkali-metal salt solution.

Further, 600 g of methanol, 600 g of water and 304 g of acetic acid were placed and cooled to -10°C in a 3-Ljacketted glass reaction container. The obtained diketopyrrolopyrrole pigment alkali-metal salt solution previously cooled at 75°C was added in small portions to the cooled mixture, which was agitated with a shear disk having a diameter of 8 cm and revolving at 4,000 rpm in a high-speed agitation disperser. Then, the diketopyrrolopyrrole pigment alkali-metal salt solution at 75°C was added thereto in small portions over approximately 120 minutes, while the mixture of methanol, acetic acid and water was kept consistently at a temperature of -5°C or lower by cooling with a refrigerant and also while the addition speed thereof was adjusted. After addition of the entire amount, dark red crystals were precipitated, giving dark red suspension. The pH of the suspension was 4.8.

(Second step)

The dark red suspension thus obtained above was washed and filtered through an Ultrafilter at 5°C. The solid matter content of the red paste obtained was 21.5%. The paste was redispersed in 3,550 g of methanol previously cooled to 0°C, to give a suspension having a methanol concentration of approximately 90%. The suspension was agitated at 5°C for 3 hours for crystal transition. The suspension is then washed and filtered through an Ultrafilter. A small amount of it was filtered, dried and then subjected to analysis by X-ray diffraction and TEM, showing that the crystalline form is alpha form and the particle is a round particle having a diameter of 20 to 40 nm. The yield amount was 103.2 g, and the yield was 79.5%.

Example 6

(First step)

The process was conducted as same as the first step of Example 5 to obtain a dark red suspension.

(Second step)

The dark red suspension thus obtained above was washed and filtered through an Ultrafilter at 5°C. The solid matter content of the red paste obtained was 21.5%. The paste was redispersed in 3,550 g of methanol previously cooled to 0°C, to give a suspension having a methanol concentration of approximately 90%. The suspension was agitated at 5°C for 3 hours for crystal transition. The suspension is then washed and filtered through an Ultrafilter. A small amount of it was filtered, dried and then subjected to analysis by X-ray diffraction and TEM, showing that the crystalline form is alpha form and the particle is a round particle having a diameter of 20 to 40 nm. Further, the red paste obtained was redispersed in 3,000 ml of water; slurry of colorant derivative prepared with 11 g of the colorant derivative (V) and 200 g of water was added thereto; the mixture was agitated at 10°C or lower for 1 hour and then filtered through an Ultrafilter to give an aqueous paste of fine diketopyrrolopyrrole pigment. The aqueous paste of the fine diketopyrrolopyrrole pigment was dried in a box drier at 80°C for 24 hours, and the dry aggregate was pulverized and processed into powder by using a hammer mill, to give a fine diketopyrrolopyrrole pigment.

The fine diketopyrrolopyrrole pigment obtained was C.I. Pigment Red 254 having an alpha-crystalline form, and the primary particle, as determined by TEM observation, was a round particle having a diameter of 20 to 40 nm. The yield amount was 114.9 g, and the yield was 79.3%.

Example 7

A fine diketopyrrolopyrrole pigment was obtained in a similar manner to Example 6, except that the slurry of

the colorant derivative (V) in Example 6 was replaced with 11 g of dry powder of the colorant derivative (VI)represented by Formula (VI).

The fine diketopyrrolopyrrole pigment obtained was C.I. Pigment Red 254 having an alpha-crystalline form, and the primary particle, as determined by TEM observation, was a round particle having a diameter of 20 to 40 nm. The yield amount was 116.0 g, and the yield was 80.1%.

Example 8

A fine diketopyrrolopyrrole pigment was prepared in a similar manner to Example 6, except that the slurry of the colorant derivative (V) in Example 6 was replaced with 11 g of dry powder of the colorant derivative(VII) represented by Formula (VII).

The fine diketopyrrolopyrrole pigment obtained was C.I. Pigment Red 254 having an alpha -crystalline form, and the primary particle, as determined by TEM observation, was a round particle having a diameter of 20 to 40 nm. The yield amount was 115.1 g, and the yield was 79.4%.

Example 9

A fine diketopyrrolopyrrole pigment was prepared in a similar manner to Example 6, except that the slurry of the colorant derivative (V) in Example 6 was replaced with 11 g of dry powder of the colorant derivative(VIII) represented by Formula (VIII).

The fine diketopyrrolopyrrole pigment obtained was C.I. Pigment Red 254 having an alpha -crystalline form, and the primary particle, as determined by TEM observation, was a round particle having a diameter of 20 to 40 nm. The yield amount was 114.3 g, and the yield was 78.8%.

Example 10

A fine diketopyrrolopyrrole pigment was prepared in a similar manner to Example 6, except that the slurry of the colorant derivative (V) in Example 6 was replaced with the mixture containing 11 g of dry powder of the colorant derivative (V) and 2 g of dry powder of the colorant derivative (VI).

The fine diketopyrrolopyrrole pigment obtained was C.I. Pigment Red 254 having an alpha -crystalline form, and the primary particle, as determined by TEM observation, was a round particle having a diameter of 20 to 40 nm. The yield amount was 116.6 g, and the yield was 79.1%.

Example 11

A fine diketopyrrolopyrrole pigment was prepared in a similar manner to Example 6, except that 600 g of methanol, 600 g of water and 304 g of acetic acid in Example 6 was replaced with that 600 g of methanol, 600 g of water and 152 g of acetic acid.

The fine diketopyrrolopyrrole pigment obtained was C.I. Pigment Red 254 having an alpha-crystalline form, and the primary particle, as determined by TEM observation, was a round particle having a diameter of 20 to 40 nm. The yield amount was 113.9 g, and the yield was 78.5%.

Example 12

(First step)

200 g of tert-amyl alcohol previously dehydrated with molecular sieve and 140 g of sodium tert-amyl alkoxide were placed in a 1-L stainless steel reaction container equipped with a reflux condenser under nitrogen environment, and the mixture was heated to 100°C under agitation, to give an alcoholate solution.

Separately, 120 g of tert-amyl alcohol previously dehydrated with molecular sieve, 88 g of diisopropyl succinate and 100 g of p-chlorobenzonitrile were placed in a 500-ml glass flask, and the mixture was heated to homogeneity to 90°C under agitation, to give a solution of the mixture thereof. The heated mixture solution was added dropwise to the alcoholate solution heated at 100°C gradually at a constant speed, while the mixture was agitated vigorously over 2 hours. After dropwise addition, the mixture was heated and agitated additionally at 90°C for 2 hours, to give a diketopyrrolopyrrole pigment alkali-metal salt solution.

Further, 600 g of methanol, 600 g of water and 304 g of acetic acid were placed and cooled to -10°C in a 3-Ljacketted glass reaction container. The obtained diketopyrrolopyrrole pigment alkali-metal salt solution previously cooled at 75°C was added in small portions to the cooled mixture. Then, the diketopyrrolopyrrole pigment alkali-metal salt

solution at 75°C was added thereto in small portions over approximately 120 minutes under high-speed agitation, while the mixture of methanol, acetic acid and water was kept consistently at a temperature of -5°C or lower by cooling with a refrigerant and also while the addition speed thereof was adjusted. After addition of the entire amount, dark red crystals were precipitated, giving dark red suspension. The pH of the suspension was 4.8.

(Second step)

The process was conducted as same as the Second step of Example 5. A small amount of sample was filtered, dried and then subjected to analysis by X-ray diffraction and TEM, showing that the crystalline form is alpha form and the particle is a round particle having a diameter of 20 to 40 nm. The yield amount was 101.0 g, and the yield was 77.8%.

Example 13

(First step)

The process was conducted as same as the first step of Example 12 to obtain a dark red suspension.

(Second step)

The process was conducted as same as the second step of Example 6 to obtain a fine diketopyrrolopyrrole pigment. The fine diketopyrrolopyrrole pigment obtained was subjected to analysis by X-ray diffraction and TEM, showing that the crystalline form is alpha form and the particle is a round particle having a diameter of 20 to 40 nm. The yield amount was 111.9 g, and the yield was 77.0%.

Comparative Example 1

170 ml of tert-amyl alcohol was placed in a 500-ml stainless steel reaction container equipped with a reflux condenser under nitrogen. 11.04 g of sodium was added, and the mixture was heated to 92 to 102°C. The mixture was heated at 100 to 107°C while the dissolved sodium was agitated vigorously, to give an alcoholate solution. A solution of 44.2 g of p-chlorobenzonitrile and 37.2 g of diisopropyl succinate dissolved in 50 ml of tert-amyl alcohol at 80°C was added dropwise to the alkoxide solution at 98°C over 2 hours. The reaction solution was agitated additionally at 80°C for 3 hours, to which 4.88 g of diisopropyl succinate then. The reaction mixture liquid was then cooled to room temperature, and dispersed in a liquid mixture of 270 ml of methanol, 200 ml of water and 48.1 g of conc. sulfuric acid at 20°C. The mixture was then agitated at 20°C for 6 hours. The red mixture was filtered, and the cake was washed with methanol and then with water and dried in a drier at 80°C, to give 41.4 g of a red powder. Comparative Example 2

81 parts of commercially available diketopyrrolopyrrole pigment (C. I. Pigment Red 254, "Irgafor Red B-CF" manufactured by Ciba Specialty Chemicals), 9 parts of colorant derivative (V), 900 parts of sodium chloride and 110 parts of diethylene glycol were placed and agitated in a "One-gallon Kneader" (manufactured by Inoue Manufacturing) for 15 hours. Then, the kneaded mixture was poured into hot water; the mixture was agitated while heated to approximately 80°C for one hour into the slurry state; the slurry was filtered; the resulting cake was washed with water for removal of sodium chloride and diethylene glycol, and then dried at 80°C for an entire day, pulverized, to give 88.1 parts of a fine diketopyrrolopyrrole pigment. The form of the fine diketopyrrolopyrrole pigment obtained was alpha-crystalline form, and the primary particle, as determined by TEM observation, is a round particle having a diameter of 20 to 40 nm.

Comparative Example 3

Commercially available diketopyrrolopyrrole pigment ("Irgafor Red B-CF" manufactured by Ciba Specialty Chemicals)

The primary particle is a round particle having a diameter of 50 to 70 nm.

The crystalline form, the primary particle diameter and shape as determined by TEM observation, and the yield of each of the fine diketopyrrolopyrrole pigments obtained in the Examples and Comparative Examples above are summarized in Table 1.

Test samples were prepared according to the method described above by using the diketopyrrolopyrrole pigments obtained in Examples 1 to 13 and Comparative Examples 1 to 2 and a commercially available diketopyrrolopyrrole pigment of Comparative Example 3 ("Irgafor Red B-CF," manufactured by Ciba Specialty Chemicals); the X-ray diffraction spectrum of each pigment was obtained; and the ratio of the peak intensity ($I_{020}$) for plane index (020) to the peak intensity ($I_{-141}$) for plane index (-141), $I_{020}/I_{-141}$ and the ratio of the peak intensity ($I_{-141}$) for plane index (-141) to the peak intensity ($I_{111}$) for plane index (111), $I_{-141}/I_{111}$ were calculated. Results are summarized in Table 2.

Table 1

| | yield | crystalline form | primary particle diameter |
|---|---|---|---|
| Example 1 | 76.0% | α | 20-40nm |
| Example 2 | 81.0% | α | 20-40nm |
| Example 3 | 80.2% | α | 10-30nm |
| Example 4 | 96.7% | α | 10-30nm |
| Example 5 | 79.5% | α | 20-40nm |
| Example 6 | 79.3% | α | 20-40nm |
| Example 7 | 80.1% | α | 20-40nm |
| Example 8 | 79.4% | α | 20-40nm |
| Example 9 | 78.8% | α | 20-40nm |
| Example 10 | 79.1% | α | 20-40nm |
| Example 11 | 78.5% | α | 20-40nm |
| Example 12 | 77.8% | α | 20-40nm |
| Example 13 | 77.0% | α | 20-40nm |
| Comparative Example 1 | 71.8% | α & β mixed | 50-70nm |
| Comparative Example 2 | 97.9% | α | 20-40nm |
| Comparative Example 3 | - | α | 50-70nm |

Table 2

| | Peak intensity ratio in X-Ray diffraction spectrum of pigment $(I_{-141})/(I_{111})$ | Peak intensity ratio in X-Ray diffraction spectrum of pigment $(I_{020})/(I_{-141})$ |
|---|---|---|
| Example 1 | 1.179 | 0.302 |
| Example 2 | 1.190 | 0.382 |
| Example 3 | 1.171 | 0.348 |
| Example 4 | 1.274 | 0.329 |
| Example 5 | 1.099 | 0.328 |
| Example 6 | 1.069 | 0.327 |
| Example 7 | 1.136 | 0.335 |
| Example 8 | 0.842 | 0.304 |
| Example 9 | 1.143 | 0.281 |
| Example 10 | 1.065 | 0.264 |
| Example 11 | 1.192 | 0.309 |
| Example 12 | 1.030 | 0.320 |
| Example 13 | 1.227 | 0.281 |
| Comparative Example 1 | 0.968 | 0.451 |
| Comparative Example 2 | 1.309 | 0.287 |

(continued)

| | Peak intensity ratio in X-Ray diffraction spectrum of pigment $(I_{-141})/(I_{111})$ | Peak intensity ratio in X-Ray diffraction spectrum of pigment $(I_{020})/(I_{-141})$ |
|---|---|---|
| Comparative Example 3 | 1.057 | 0.464 |

Examples 14 to 17 and Comparative Examples 4 to 6

The coloring composition containing each of the diketopyrrolopyrrole pigments obtained in Examples 1 to 4 and Comparative Examples 1 to 2 or the commercially available diketopyrrolopyrrole pigment of Comparative Example 3 was prepared according to the method of preparing a pigment dispersion paste described below.

(Preparation of a pigment dispersion paste)

Each of the diketopyrrolopyrrole pigments was mixed with a resin type pigment dispersant, acrylic resin solution 1, and an organic solvent according to the following formulation, and the mixture was dispersed at 320 rpm for 4 hours in a planetary ball mill (planetary ball mill P-5 manufactured by Fritsch Japan Co., Ltd.) using 290 g of zirconia beads of 0.5 mm in diameter to prepare a pigment paste.

| | |
|---|---|
| Diketopyrrolopyrrole pigments | 17.3 g |
| 30% Solution of Ajisper PB821 (manufactured by Ajinomoto Co., Ltd.) in cyclohexanone | 5.8 g |
| Acrylic resin solution 1 (solid content: 20%) | 62.1 g |
| Cyclohexanone | 54.8 g |

The acrylic resin solution 1 used in preparation of the pigment dispersion paste above was prepared in the following manner.

(Preparation of acrylic resin solution 1)

800 Parts of cyclohexanone was placed in a reaction container and heated to 100°C with introducing a nitrogen gas into the container and, at the same temperature, a mixture of 60.0 g of styrene, 60.0 g of methacrylic acid, 65.0 g of methyl methacrylate, 65.0 g of butyl methacrylate and 10.0 g of azobisisobutyronitrile was added dropwise thereto over 1 hour, allowing progress of polymerization reaction. After completion of the dropwise addition, the reaction was continued for further 3 hours at 100°C, a solution of 2.0 g of azobisisobutyronitrile in 50 g of cyclohexanone was added thereto, followed by continuing the reaction for further 1 hour at 100°C to synthesize a resin solution. After cooling it to room temperature, 2 g of the resin solution was sampled and heat-dried at 180°C for 20 minutes to measure non-volatile components. Cyclohexanone was added so that the content of the non-volatile components in the formerly synthesized resin solution became 20%, thus an acrylic resin solution being prepared.

(Preparation of a light-sensitive coloring composition)

Each of the pigment dispersion pastes was compounded as shown below and, after uniformly mixing by agitation, the mixture was filtered through a 1-μm filter to prepare an alkali-developable light-sensitive coloring composition:

| | |
|---|---|
| Pigment dispersion pastes | 36.4 g |
| Acrylic resin solution 1 | 5.6 g |
| Trimethylolpropane triacrylate (NK Ester ATMPT manufactured by Shin-Nakamura Chemical Co., Ltd.) | 5.4 g |
| Photo initiator (Irgacure 907 manufactured by Ciba Specialty Chemicals) | 0.3 g |
| Sensitizing agent (EAB-F manufactured by Hodogaya Chemical Co., Ltd.) | 0.2 g |
| Cyclohexanone | 52.1 g |

Examples 18 to 26 and Comparative Example 7

A coloring composition containing the coloring composition containing each of the diketopyrrolopyrrole pigments

obtained in Examples 5 to 13 and Comparative Example 2 was prepared according to the method of preparing a pigment dispersion paste described below.

(Chip production method)

A diketopyrrolopyrrole pigment was blended in the following composition with the colorant derivative (V), the acrylic resin solution 2, and an organic solvent sufficiently, and then the mixture was kneaded in a 2-roll mill into a sheet-shaped molding. The sheet-shaped molding was folded several times and kneaded again in the 2-roll mill. The operation is repeated 10 to 40 times, and the resulting molding was crushed with a crusher, to give co-red chips.

| | |
|---|---|
| Diketopyrrolopyrrole pigment | 97.0 g |
| Colorant derivative (V) | 11.0 g |
| Acrylic resin solution 2 (solid content: 20%) | 360.0 g |

The acrylic resin solution 2 used in preparation of the pigment dispersion paste above was prepared in the following manner:

(Preparation of acrylic resin solution 2)

370 g of cyclohexanone was placed in a reaction container and heated to 80°C with introducing a nitrogen gas into the container and, at the same temperature, a mixture of 20.0 g of methacrylic acid, 10.0 g of methyl methacrylate, 35.0 g of n-butyl methacrylate, 15.0 g of 2-hydroxyethyl methacrylate, 4.0 g of 2,2'-azobisisobutylonitrile, and 20.0 g of p-cumylphenol ethyleneoxide-modified acrylate ("ARONIX M110," manufactured by Toagosei Co., Ltd.) was added dropwise thereto over 1 hour, allowing progress of polymerization reaction. After completion of the dropwise addition, the reaction was continued for further 3 hours at 80°C, a solution of 1.0 g of azobisisobutyronitrile in 50 g of cyclohexanone was added thereto, followed by continuing the reaction for further 1 hour at 80°C to synthesize a resin solution. After cooling it to room temperature, 2 g of the resin solution was sampled and heat-dried at 180°C for 20 minutes to measure non-volatile components. Cyclohexanone was added so that the content of the non-volatile components in the formerly synthesized resin solution became 20%, thus an acrylic resin solution being prepared.

(Preparation of a pigment dispersion paste)

After the mixture comprised compositions below is uniformly mixing by agitation, the mixture was dispersed at 320 rpm for 4 hours in a planetary ball mill (planetary ball mill P-5 manufactured by Fritsch Japan Co., Ltd.) using 290 g of zirconia beads of 0.5 mm in diameter to prepare a pigment paste.

| | |
|---|---|
| Co-red chip prepared in advance | 25.2 g |
| Cyclohexanone | 23.0 g |
| Propylene glycol monomethyl ether | 91.8 g |

(Preparation of a light-sensitive coloring composition)

Each of the pigments was compounded as shown below and, after uniformly mixing by agitation, the mixture was filtered through a 1-μm filter to prepare an alkali-developable light-sensitive coloring composition.

| | |
|---|---|
| Pigment dispersion pastes | 36.4 g |
| Acrylic resin solution 2 | 5.6 g |
| Trimethylolpropane triacrylate (NK Ester ATMPT manufactured by Shin-Nakamura Chemical Co., Ltd.) | 5.4 g |
| Photo polymerization initiator (Irgacure 907 manufactured by Ciba Specialty Chemicals) | 0.3 g |
| Sensitizing agent (EAB-F manufactured by Hodogaya Chemical Co., Ltd.) | 0.2 g |
| Cyclohexanone | 52.1 g |

(Application of photosensitive coloring composition and preparation of test substrate)

Each photosensitive coloring composition obtained was applied on a glass plate of 100 mm x 100 mm and 1.1

mm in thickness by using a spin coater to a film thickness giving a coated film having an X value in chromaticity coordinate of 0.64 after ultraviolet ray exposure and heating, to give a coated substrate. Then, it was dried at 70°C for 20 minutes, and then, exposed to the ultraviolet ray from an ultrahigh-pressure mercury lamp at an integrated light intensity of 150 mJ. After exposure, the substrate was heated to 230°C for 1 hour and then cooled, to give a coated substrate sample.

The contrast ratio and the birefringence of the test substrate obtained were determined according to the following test methods. The X-ray diffraction spectrum of the substrate was determined by the method described above, and the ratio of the peak intensity ($I_{020}$) for plane index (020) to the peak intensity ($I_{-141}$) for plane index (-141), $I_{020}/I_{-141}$ was calculated. Results are summarized in Table 3.

Table 3

| | Contrast | Absolute birefringence of red colored film at 580 nm | Peak intensity ratio in X-Ray diffraction spectrum of pigment ($I_{020}$)/ ($I_{-141}$) |
|---|---|---|---|
| Example 14 | 2150 | 0.0067 | 2.185 |
| Example 15 | 1850 | 0.0047 | 2.643 |
| Example 16 | 2442 | 0.0038 | 2.531 |
| Example 17 | 2500 | 0.0064 | 1.842 |
| Example 18 | 4161 | 0.0078 | 2.248 |
| Example 19 | 5106 | 0.0091 | 2.718 |
| Example 20 | 5133 | 0.0081 | 2.506 |
| Example 21 | 6120 | 0.0089 | 2.391 |
| Example 22 | 5622 | 0.0104 | 3.223 |
| Example 23 | 7329 | 0.0087 | 4.384 |
| Example 24 | 4659 | 0.0103 | 2.810 |
| Example 25 | 3307 | 0.0076 | 2.560 |
| Example 26 | 4998 | 0.0069 | 2.283 |
| Comparative Example 4 | 582 | 0.0113 | 3.782 |
| Comparative Example 5 | 2105 | 0.0245 | 0.991 |
| Comparative Example 6 | 438 | 0.0090 | 4.142 |
| Comparative Example 7 | 5907 | 0.0185 | 1.039 |

(Measurement of contrast)

A coated substrate sample was held between a pair of polarization plates, the brightness of the sample when the polarization plate is in parallel to polarization face of light and that when it is placed in the cross direction to polarization face of light were determined using a "color luminance meter BM-5 A" manufactured by Topcon Corporation. The deflection plate used was a "deflection film LLC2-92-18" manufactured by Sanritsu Corp. During measurement of the brightness, a black mask having an opening of 1 cm square was bonded to the test region for screening of undesired light. The contrast was calculated from the brightness when in parallel and that when placed in the cross direction, according to the following Formula:

$$\text{Contrast} = \text{Brightness when in parallel} / \text{Brightness when in cross}$$

(Measurement of birefringence)

Three-dimensional refractive index was determined by using a spectroscopic ellipsometer ("M-220S," manufactured by JASCO Corp.); and the birefringence ($\Delta n = n_{xy}$-$n_z$) was calculated from the refractive index $\mathbf{n_{xy}}$ in the xy plane and the refractive index $n_z$ in the Z axis direction at 580 nm, which are obtained by using the film thickness as determined with a stylus profilometer.

The red colored films containing the $\alpha$-diketopyrrolopyrrole pigments of the present invention prepared in Examples have lower absolute birefringence, are more favorable in visibility in the inclined direction, and have higher contrast ratio, compared to those of the red colored films containing the diketopyrrolopyrrole pigments produced in Comparative Examples and currently widely-used commercially available diketopyrrolopyrrole pigment (Irgafor Red B-CF).

The commercially available diketopyrrolopyrrole pigment (Irgafor Red B-CF: manufactured by Ciba Specialty Chemicals) is particles of 50 to 70 nm, when observed under TEM, and it is likely that the crystallinity in a particular crystal plate is increased in a production method of pulverizing a pigment by salt milling by using such large particles. High peak intensities in the laminating directions at 2$\theta$ of 25.8 and 28.3 in the X-ray diffraction spectrum indicate high crystallinity in the directions. Probably for that reason, the peak intensity ratio $I_{-141}/I_{111}$ of the pigment is larger than 1.28.

On the other hand, even by a production method of using the salt milling method, if the salt milling was carried out by using the diketopyrrolopyrrole pigment particle of 20 to 50 nm in size (C.I. Pigment Red 254), which was prepared by forming fine particles and the causing crystal transition in an alcohol having 1 to 4 carbon atoms medium and controlling the particle diameter (as Example 4), there is no drastic unidirectional crystal growth in the laminating direction and the hydrogen-bonding direction, compared to the case above. In this way, it is possible to adjust the absolute birefringence of the red colored film containing the pigment in the favorable range of the present invention and to reduce the view-angle dependence of the resulting color filter.

## Claims

1. An [alpha]-diketopyrrolopyrrole pigment, wherein in the X-ray diffraction spectrum of the pigment, the ratio of the peak intensity ($I_{020}$) for plane index (020) that corresponds to peak intensity of 7.5 degrees in double glancing angles (2 theta) of the X-ray diffraction pattern, to the peak intensity ($I$-$_{141}$) for plane index (-141), that corresponds to peak intensity of 25.8 degrees in double glancing angles (2 theta) of the X-ray diffraction pattern, $I_{020}/I$-$_{141}$ is 0.40 or lower, and the ratio of the peak intensity ($I_{-141}$ for plane index (-141) to the peak intensity ($I_{111}$) for plane index (111), that corresponds to peak intensity of 24.7 degrees in double glancing angles (2theta) of the X-ray diffraction pattern, $I_{-141}/I_{111}$ is 1.28 or lower.

2. The [alpha]-diketopyrrolopyrrole pigment according to claim 1, wherein the average primary particle diameter of [alpha]-diketopyrrolopyrrole is 40 nm or less.

3. A coloring composition, containing the [alpha]-diketopyrrolopyrrole pigment according to claim 1 or 2 and a carrier for the pigment.

4. A red colored film, **characterized by** containing the [alpha]-diketopyrrolopyrrole pigment according to claim 1 or 2 and a pigment carrier.

5. The red colored film according to claim 4, wherein the ratio of the peak intensity ($I_{020}$) for plane index (020) to the peak intensity ($I_{-141}$) for plane index (-141), $I_{020}/I$-$_{141}$, in the X-ray diffraction spectrum of the red colored film is 1.5 or more and 4.5 or less.

6. The red colored film according to claim 5, wherein the absolute birefringence of the red colored film at a wavelength of 580 nm is 0 to 0.01.

## Patentansprüche

1. Alpha]-diketopyrrolopyrrol-Pigment, wobei im Röntgendiffraktionsspektrum des Pigments das Verhältnis der Peakintensität ($I_{020}$) für den Gitterebenenindex (020) - entsprechend einer Peakintensität von 7.5 Grad am doppelten Glanzwinkel (2 theta) des Röntgendiffraktionsmusters - zur Peakintensität ($I$-$_{141}$) für den Gitterebenenindex (-141), - entsprechend einer Peakintensität von 25.8 Grad am doppelten Glanzwinkel (2 theta) des Röntgendiffraktionsmus-

ters, $I_{020}/I_{-141}$,. 0.40 oder kleiner ist, und das Verhältnis der Peakintensität ($I_{-141}$) für den Gitterebenenindex (-141) zur Peakintensität ($I_{111}$) für den Gitterebenenindex (111) - entsprechend einer Peakintensität von 24.7 Grad am doppelten Glanzwinkel (2theta) des Röntgendiffraktionsmusters, $I_{-141}/I_{111}$, 1.28 oder kleiner ist.

2. [Alpha]-diketopyrrolopyrrol-Pigment nach Anspruch 1, wobei der durchschnittliche Partikel-Hauptdurchmesser des [Alpha]-diketopyrrolopyrrols 40 nm oder weniger ist.

3. Färbende Zusammensetzung, umfassend das [Alpha]-diketopyrrolopyrrol-Pigment nach Anspruch 1 oder 2 und einen Träger für das Pigment.

4. Rot gefärbter Film, **gekennzeichnet durch** einen Gehalt an [Alpha]-diketopyrrolopyrrol-Pigment nach Anspruch 1 oder 2 und einem Pigment Träger.

5. Rot gefärbter Film nach Anspruch 4, wobei das Verhältnis der Peakintensität ($I_{020}$) für den Gitterebenenindex (020) zur Peakintensität ($I_{-141}$) für den Gitterebenenindex (-141), $I_{020}/I_{-141}$ des Röntgendiffraktionsspektrums des rot gefärbten Films 1.5 oder mehr und 4.5 oder weniger ist.

6. Rot gefärbter Film nach Anspruch 5, wobei der Absolutwert der Doppelbrechung des rot gefärbten Films bei einer Wellenlänge von 580 nm 0 bis 0.01 beträgt.

## Revendications

1. Pigment de [alpha]-dicétopyrrolopyrrole, où, dans le spectre de diffraction X du pigment, le rapport de l'intensité du pic ($I_{020}$) pour le plan d'indice (020) correspondant à une intensité de pic de 7,5 degrés d'angle de déviation (2-thêta) du motif de diffraction X, sur l'intensité du pic ($I_{-141}$) pour le plan d'indice (-141), qui correspond à l'intensité de pic de 25,8 degrés d'angle de déviation (2-thêta) du motif de diffraction X, $I_{020}/I_{-141}$ est de 0,40 ou moins, et le rapport de l'intensité du pic ($I_{-141}$) pour le plan d'indice (-141) sur l'intensité du pic ($I_{111}$) pour le plan d'indice (111), qui correspond à l'intensité de pic de 24,7 degrés d'angle de déviation (2-thêta) du motif de diffraction X, $I_{-141}/I_{111}$ est de 1,28 ou moins.

2. Pigment de [alpha]-dicétopyrrolopyrrole selon la revendication 1, où la granulométrie principale moyenne du [alpha]-dicétopyrrolopyrrole est de 40 nm ou moins.

3. Composition colorante, contenant le pigment de [alpha]-dicétopyrrolopyrrole selon la revendication 1 ou 2 et un vecteur pour le pigment.

4. Pellicule colorée en rouge, **caractérisée en ce qu'**elle contient le pigment de [alpha]-dicétopyrrolopyrrole selon la revendication 1 ou 2 et un vecteur de pigment.

5. Pellicule colorée en rouge selon la revendication 4, où le rapport de l'intensité du pic ($I_{020}$) pour le plan d'indice (020) sur l'intensité du pic ($I_{-141}$) pour le plan d'indice (-141) , $I_{020}/I_{-141}$, dans le spectre de diffraction X de la pellicule colorée en rouge est de 1,5 ou plus ou de 4,5 ou moins.

6. Pellicule colorée en rouge selon la revendication 5, où la biréfringence absolue de la pellicule colorée en rouge à une longueur d'onde de 580 nm est comprise entre 0 et 0,01.

Fig.1

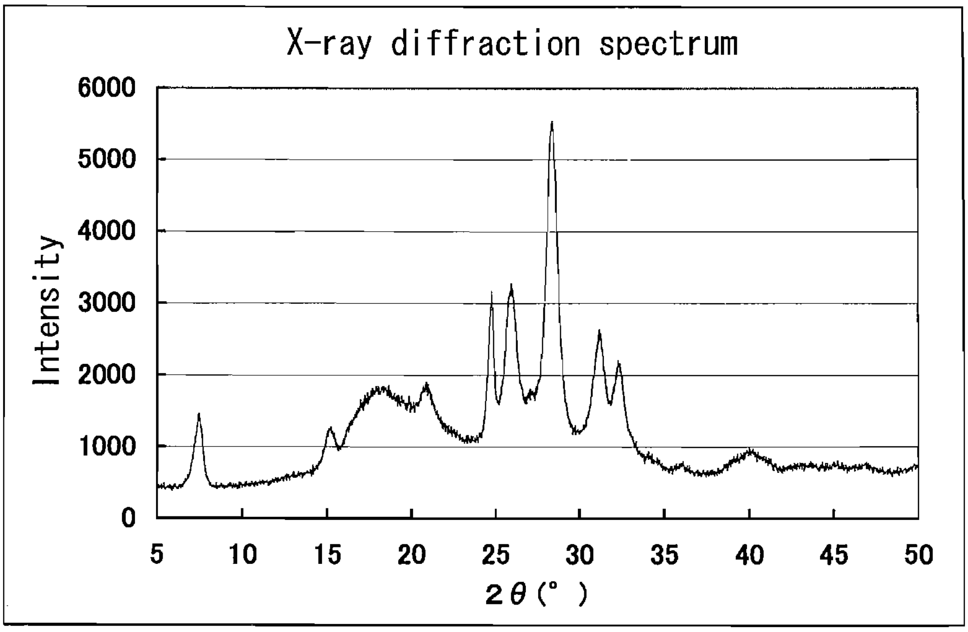
X-ray diffraction spectrum
Intensity
6000
5000
4000
3000
2000
1000
0
5
10
15
20
25
30
35
40
45
50
2θ(° )

Fig.2

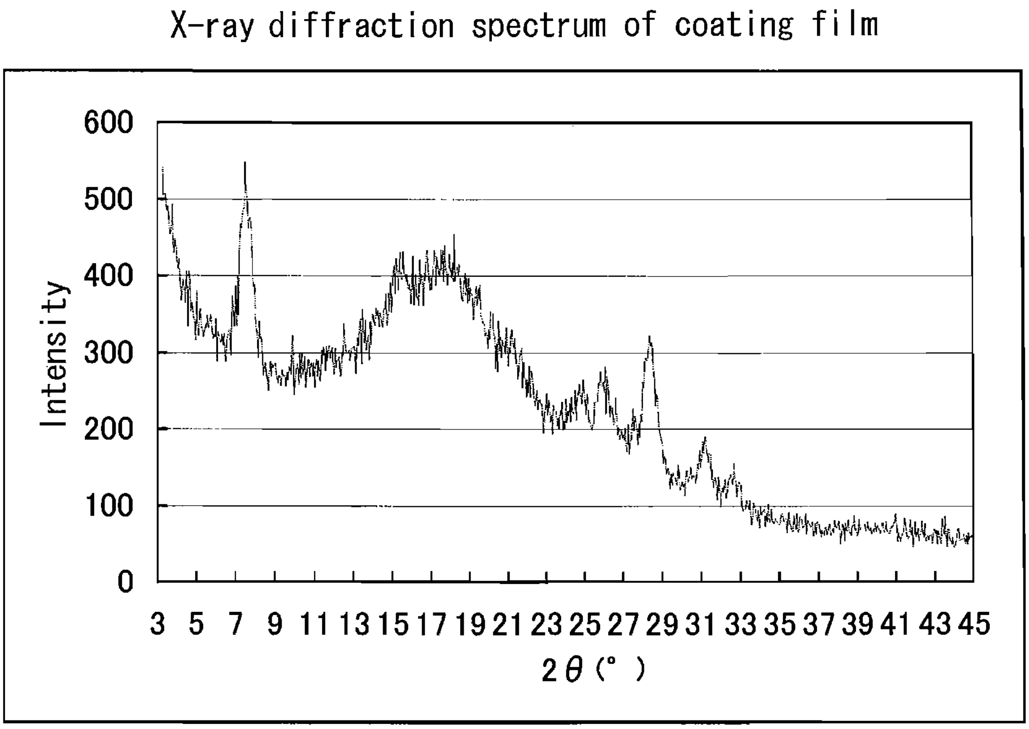
X-ray diffraction spectrum of coating film
Intensity
600
500
400
300
200
100
0
3 5 7 9 11 13 15 17 19 21 23 25 27 29 31 33 35 37 39 41 43 45
2θ(° )

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2005002249 A
- EP 11018900 A1
- JP 2001220520 A
- JP 2005189672 A
- JP 7090189 A
- JP 58210084 A